(19) Europäisches Patentamt / European Patent Office / Office européen des brevets

(11) **EP 4 183 048 B1**

(12) **EUROPÄISCHE PATENTSCHRIFT**

(45) Veröffentlichungstag und Bekanntmachung des Hinweises auf die Patenterteilung:
**27.08.2025 Patentblatt 2025/35**

(21) Anmeldenummer: **21786893.4**

(22) Anmeldetag: **04.10.2021**

(51) Internationale Patentklassifikation (IPC):
*H03K 17/96* (2006.01)    *B62D 1/04* (2006.01)
*B62D 1/06* (2006.01)

(52) Gemeinsame Patentklassifikation (CPC):
**H03K 17/962; B62D 1/046; B62D 1/065;**
H03K 2017/9602; H03K 2217/96072;
H03K 2217/96073; H03K 2217/960765

(86) Internationale Anmeldenummer:
**PCT/EP2021/077265**

(87) Internationale Veröffentlichungsnummer:
**WO 2022/073914 (14.04.2022 Gazette 2022/15)**

(54) **VORRICHTUNG UND VERFAHREN ZUR KAPAZITIVEN BERÜHRUNGSDETEKTION**

APPARATUS AND METHOD FOR CAPACITIVE TOUCH DETECTION

DISPOSITIF ET PROCÉDÉ DE DÉTECTION DE CONTACT CAPACITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.10.2020 DE 102020126110**

(43) Veröffentlichungstag der Anmeldung:
**24.05.2023 Patentblatt 2023/21**

(73) Patentinhaber: **Preh GmbH**
**97616 Bad Neustadt a.d. Saale (DE)**

(72) Erfinder:
- **GASPAR, Zoltan**
  **500002 Brasov, Jud. Brasov (RO)**
- **CIOCEA, Daniel**
  **500222 Brasov (RO)**
- **NAGY-GAUDI, Arpad**
  **520008 jud. Covasna (RO)**

(74) Vertreter: **Lohmanns, Bernard**
**Benrather Schlossallee 49-53**
**40597 Düsseldorf (DE)**

(56) Entgegenhaltungen:
WO-A1-97/01835    US-A1- 2008 122 458
US-A1- 2013 076 374

## Beschreibung

Die vorliegende Erfindung betrifft eine Vorrichtung zur kapazitiven Berührungsdetektion nach dem Oberbegriff des Anspruchs 1 sowie ein Verfahren zur kapazitiven Berührungsdetektion nach dem Oberbegriff des Anspruchs 12.

Die kapazitive Berührungsdetektion in Verbindung mit zum Beispiel Berührungssensoren, Näherungssensoren und dergleichen findet Anwendung in einer Vielzahl von Bereichen einschließlich des Automobilbereichs, der Unterhaltungselektronik und der Medizintechnik.

Berührungssensoren und Näherungssensoren können beispielsweise als Schaltflächen, Schieberegler oder Schalter einer Benutzeroberfläche fungieren. Diese Sensoren befinden sich beispielsweise in Fahrzeugen, an elektronischen Handgeräten, Haushaltsgeräten etc. Sie können durch Drücken mit einem Finger, Berühren eines Bildschirms mit einem Eingabestift oder sogar durch die alleinige Anwesenheit eines Körpers an einen Näherungssensor bedient werden.

Die Sensoren selbst wirken als Kondensator bzw. Kapazität. Wenn der Sensor gedrückt wird oder wenn sich ihm ein Körper nähert, ändern sich die Kapazitätseigenschaften des Sensors. Durch Bestimmen des Wertes der Kapazität oder durch einen Vergleich mit einem bekannten Wert oder zuvor ermittelten Werten können Informationen gewonnen werden wie beispielsweise, ob ein Kontakt zum Sensor hergestellt wurde oder wie lange ein Kontakt hergestellt wurde. Gewöhnlich wird hierzu das so genannte CVD-Verfahren (Capacitive Voltage Devider) verwendet, das an sich wohl bekannt ist. Derartige Verfahren beruhen auf einer Stromintegration beim Laden und Entladen von Kapazitäten. US 10 352 731 B2 beschreibt beispielhaft eine mögliche Vorrichtung zur kapazitiven Berührungsdetektion. Die Vorrichtung weist mehrere Berührelektroden bzw. Berührungssensoren, einen Signalgenerator zur Erzeugung eines elektrischen Signals, das den Berührelektroden zuführbar ist, und eine elektronische Mikrocontrollereinheit auf. Die Mikrocontrollereinheit steuert einen Touch-Controller, der wiederum die einzelnen Berührungssensoren ansteuert.

Herkömmliche Verfahren zur Berührungsdetektion, wie beispielsweise das CVD-Verfahren, sind allgemein rauschempfindlich und anfällig gegenüber äußeren elektrischen Störeinflüssen. Darüber hinaus werden die Berührungssensoren bei CVD-Verfahren zum Laden und Entladen der Sensorkapazität mit Strömen angesteuert, die steile Flanken aufweisen, was dementsprechend zu breitbandiger elektromagnetischer Abstrahlung auf langen Zuleitungen, die als Antennen wirken, führen kann.

Aus der US 2008/122458 A1 und der WO 97/01835 A1 sind jeweils eine Vorrichtung bzw. ein Verfahren gemäß dem Oberbegriff der unabhängigen Ansprüche bekannt. Die US 2013/076374 A1 offenbart ein gattungsgemäßes Verfahren.

Vor diesem Hintergrund liegt der vorliegenden Erfindung die Aufgabe zugrunde, eine Vorrichtung sowie ein Verfahren zur kapazitiven Berührungsdetektion bereitzustellen, die mit einfacheren Mitteln eine zuverlässige Detektion einer Annäherung bzw. Berührung eines Berührungssensors (hierin auch als Berührelektrode bezeichnet) mit einem Objekt, z. B. ein Finger einer Person, gewährleistet. Sie sollen weiterhin unempfindlich gegenüber Störeinflüssen (z. B. Rauschen) sein und ein verbessertes, d. h. insbesondere reduziertes, elektromagnetisches Abstrahlverhalten aufweisen. Die einfacheren Mittel zur Berührungsdetektion sollen die Verwendung kostengünstigerer elektronischer Komponenten (z. B. Rechen-/Steuereinheiten) ermöglichen und Einsatz beispielsweise von Touch-Controllern zur dedizierten Ansteuerung der Berührungssensoren (z. B. Stromtreiber) erübrigen. Hohe Detektionsempfindlichkeit, gute Rauschunterdrückung und eine sehr geringe Rate falsch-positiver Berührungserkennungen (auch als "Ghost Touch" bezeichnet) sollen weitere vorteilhafte Eigenschaften der erfindungsgemäßen Vorrichtung sowie des Verfahrens sein.

Diese Aufgabe wird durch eine Vorrichtung mit den Merkmalen des Anspruchs 1 sowie durch ein Verfahren mit den Merkmalen des Anspruchs 12 gelöst. Darüber hinaus wird die Aufgabe durch ein Lenkrad für ein Kraftfahrzeug mit den Merkmalen des Anspruchs 19 gelöst. Weitere, besonders vorteilhafte Ausgestaltungen der Erfindung offenbaren die jeweiligen Unteransprüche.

Es ist darauf hinzuweisen, dass die in den Ansprüchen einzeln aufgeführten Merkmale in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Es sei ferner angemerkt, dass eine hierin nachstehend verwendete, zwischen zwei Merkmalen stehende und diese miteinander verknüpfende Konjunktion "und/oder" stets so auszulegen ist, dass in einer ersten Ausgestaltung des erfindungsgemäßen Gegenstands lediglich das erste Merkmal vorhanden sein kann, in einer zweiten Ausgestaltung lediglich das zweite Merkmal vorhanden sein kann und in einer dritten Ausgestaltung sowohl das erste als auch das zweite Merkmal vorhanden sein können.

Ein hierin verwendeter Begriff "etwa" gibt einen Toleranzbereich an, den der auf dem vorliegenden Gebiet tätige Fachmann als üblich ansieht. Insbesondere ist unter dem Begriff "etwa" ein Toleranzbereich der bezogenen Größe von bis maximal +/-20 %, bevorzugt bis maximal +/-10 % zu verstehen.

Eine erfindungsgemäße Vorrichtung zur kapazitiven Berührungsdetektion weist wenigstens eine Berührelektrode (hierin auch als Berührungssensor bezeichnet) mit einer Kapazität zur Erfassung einer Kapazitätsänderung bei Annäherung eines Objekts, z. B. eines Fingers, an die Berührelektrode auf. Weiterhin weist die Vorrichtung einen Signalgenerator zur Erzeugung wenigstens eines vorbestimmten periodischen Signals mit vorbestimmter Frequenz und Phase auf, das der Berührelektrode elektrisch zugeführt ist. Als Signalgenerator ist daher eine elektronische Komponente, Baugruppe oder Schaltung zu verstehen, die elektrische Spannungen mit einem charakteristischen Zeitverlauf erzeugt. Weiterhin weist die Vorrichtung gemäß der Erfindung eine elektronische Recheneinheit auf, die beispielsweise ein Mikrocontroller ist.

Erfindungsgemäß ist der Signalgenerator vermittels eines ohmschen Widerstands derart mit der Berührelektrode elektrisch gekoppelt, dass der ohmsche Widerstand und die Kapazität der Berührelektrode bezüglich des der Berührelektrode zugeführten, vom Signalgenerator erzeugten Signals ein RC-Filter bilden. Die Recheneinheit ist wenigstens dazu eingerichtet, das von dem RC-Filter gefilterte Signal zu empfangen und eine Abweichung des gefilterten Signals gegenüber dem erzeugten Signal auszuwerten. Mit anderen Worten ist die kapazitive Berührelektrode selbst Teil des RC-Filters, das die Amplitude und/oder Phase des vom Signalgenerator erzeugten, zugeführten Signals verändert. Die Recheneinheit wertet dementsprechend die Amplitude und/oder Phase des gefilterten Signals im Hinblick auf eine Abweichung zu dem ursprünglich vom Signalgenerator erzeugten und zugeführten Signal aus. Dies bedeutet auch, dass die Berührelektrode zwei elektrische Anschlusspunkte zur Berührdetektion im Sinne der Erfindung bereitstellt, nämlich einen ersten eingangsseitigen Anschlusspunkt vor dem die Berührelektrode aufweisenden RC-Filter, an dem der Signalgenerator bzw. Signalgeneratorausgang angeschlossen ist, und einen zweiten ausgangsseitigen Anschlusspunkt hinter dem RC-Filter. Die beiden Anschlusspunkte ermöglichen den Vergleich des eingangsseitig zugeführten Signals und/oder Signalform mit dem ausgangsseitig gefilterten Signal und/oder Signalform, um letztendlich aus einer detektierten Abweichung der beiden Signale eine Annäherung an die und/oder Berührung der Berührelektrode abzuleiten.

Es ist zu verstehen, dass der Signalgenerator als eigenständige elektronische, insbesondere digitale, Komponente ausgebildet sein kann. Er kann jedoch ebenso als Teil der Recheneinheit bzw. durch die Recheneinheit selbst gebildet sein. Beispielsweise kann die Signalerzeugung durch Verfahren der direkten digitalen Synthese (DDS) erzeugt werden, ohne jedoch zwingend hierauf beschränkt zu sein. Die direkte digitale Synthese bietet die Möglichkeit, periodische, bandbegrenzte Signale mit sehr feiner Frequenzauflösung zu erzeugen. Die zur Signalerzeugung erforderlichen Signalparameter können dem Signalgenerator beispielsweise über die Recheneinheit bereitgestellt werden, ohne jedoch zwingend hierauf beschränkt zu sein. Zum Beispiel kann die Recheneinheit (z. B. Mikrocontroller) eine Speichereinheit, wie beispielsweise RAM-, ROM-, Flash-Speicher und dergleichen, aufweisen, in welcher die Signalparameter gespeichert sein können. Ein Speicherzugriff des Signalgenerators auf die Signalparameter kann zudem über so genannte DMA-Mechanismen (Direct Memory Acces) zusätzlich vereinfacht und insbesondere beschleunigt werden.

Die Erkennung der Annäherung des Objekts an die Berührelektrode soll im Sinne der Erfindung ebenso eine Erkennung einer Berührung der Berührelektrode einschließen, so dass die erfindungsgemäße Vorrichtung sowohl eine Näherungsdetektion und/oder eine (reine) Berührungsdetektion verwirklichen kann.

Überraschenderweise wurde festgestellt, dass die Annäherungs-/Berührungsdetektion basierend auf der Änderung der Kapazitätseigenschaften der Berührelektrode infolge der Annäherung/Berührung durch das Objekt (z. B. Finger) mittels des RC-Filters, dessen kapazitive Komponente die Berührelektrode selbst bildet, wesentlich zuverlässiger ist, als beispielsweise durch ein herkömmliches CVD-Verfahren ("Capacitive Voltage Devider"-Verfahren), bei welchem die Kapazitätseigenschaften eines Berührungssensors in bekannter Weise mittels einer Stromintegration beim Laden/Entladen des Sensors ermittelt werden. Dies ist unter anderem darauf zurückzuführen, dass die Erzeugung des durch das RC-Filter gefilterten Signals wesentlich weniger anfällig gegenüber elektrischen Störeinflüssen, wie z. B. Rauschen und dergleichen, ist, so dass die Änderung der Kapazitätseigenschaften der Berührelektrode, die sich grundsätzlich in einem verhältnismäßig kleinen elektrischen Signal niederschlägt, das gewöhnlich durch ein diesem gegenüber verhältnismäßig großes Rauschsignal überlagert sein kann, zuverlässiger detektiert werden kann.

Zudem lässt sich die erfindungsgemäße Vorrichtung mit einfachen Mitteln realisieren. Beispielsweise können als Recheneinheit kostengünstige Standard-Mikrocontroller verwendet werden, und das RC-Filter erfordert neben der kapazitiven Berührelektrode lediglich einen weiteren ohmschen Widerstand. Auf spezielle Touch-Controller zur Ansteuerung der Berührelektrode bzw. einer Vielzahl von Berührelektroden kann bei der erfindungsgemäßen Vorrichtung verzichtet werden. Die Anforderungen an die Recheneinheit u. a. bezüglich ihrer Rechenleistung sind deutlich geringer als beispielsweise bei auf einer Stromintegration basierenden Verfahren. Das vom Signalgenerator erzeugte Signal kann der Berührelektrode zum Beispiel über einen verhältnismäßig langen Zeitraum oder sogar kontinuierlich zugeführt werden. Während dieses Zeitraums kann die Recheneinheit die Amplitude und/oder Phase des gefilterten Signals auswerten.

Weiterhin ist es möglich, die erfindungsgemäße Vorrichtung mit einem verbesserten, das heißt deutlich reduzierten, elektromagnetischen Abstrahlverhalten bereitzustellen. Dies kann zum Beispiel über die vorbestimmbare Frequenz des zu erzeugenden Signals erzielt werden. Im Gegensatz zu Verfahren, die auf dem Laden und Entladen der Berührelektrode beruhen, wobei Ströme mit steilen Signalflanken auftreten, die wiederum ein breitbandiges Signalspektrum zur Folge haben, das insbesondere Signalanteile mit hohen Frequenzen beinhaltet, weist das erzeugte Signal der erfindungsgemäßen Vorrichtung eine fest vorgegebene Frequenz auf, die zudem verhältnismäßig niedrig gewählt werden kann, z. B. im Bereich von einigen wenigen bis einigen zehn Kilohertz mit entsprechenden Wellenlängen im Kilometer-Bereich. Bei der Übertragung eines solchen Signals selbst auf langen elektrischen Leitungen stellen diese sehr ineffiziente Antennen dar, so dass die elektromagnetische Abstrahlung im Wesentlichen vernachlässigt werden kann.

Insgesamt erreicht die erfindungsgemäße Vorrichtung somit u. a. eine hohe Detektionsempfindlichkeit, eine wirkungsvolle Rauschunterdrückung und ein geringes elektromagnetisches Abstrahlverhalten.

Eine vorteilhafte Ausgestaltung der Erfindung sieht vor, dass ein das erzeugte Signal bereitstellender Ausgang des Signalgenerators, der ohmsche Widerstand und die Berührelektrode, das heißt die Kapazität der Berührelektrode, in Reihe geschaltet sind, wodurch das gebildete RC-Filter Tiefpasseigenschaften aufweist und das der Berührelektrode zugeführte und vom Signalgenerator zu erzeugende Signal eine verhältnismäßig niedrige Frequenz aufweisen kann, vorzugsweise im Bereich einiger Kilohertz und darunter.

Eine vorteilhafte Weiterbildung des Erfindungsgegenstands sieht vor, dass die Recheneinheit eingerichtet ist, eine elektrische Spannung (im Gegensatz zu einem elektrischen Strom) des gefilterten Signals (d. h. eine ausgangsseitige Spannung des RC-Filters) auszuwerten.

Weiterhin kann gemäß einer bevorzugten Ausgestaltung die von der

Recheneinheit ausgewertete Abweichung des gefilterten Signals gegenüber dem erzeugten Signal eine Phasenverschiebung sein, ohne jedoch zwingend hierauf beschränkt zu sein. Eine Abweichung der Signalamplitude des gefilterten Signals gegenüber dem ursprünglich erzeugten Signal kann ebenfalls zur Detektion einer Annäherung/-Berührung der Berührelektrode herangezogen werden, um die Detektionsvorrichtung beispielsweise im Hinblick auf äußere (insbesondere elektromagnetische) Störeinflüsse und/oder intrinsisches Rauschen weiter zu verbessern, insbesondere robuster zu machen, um die Qualität der Signalauswertung zu erhöhen. Es hat sich allerdings gezeigt, dass sich eine durch das RC-Filter bewirkte Phasenverschiebung des Signals bereits bei niedrigeren Frequenzen zeigt als eine Amplitudenänderung, so dass die Auslegung der Recheneinheit auf die Auswertung der Phasenverschiebung eine besonders bevorzugte Variante der erfindungsgemäßen Vorrichtung darstellt. Die Verwendung des zu erzeugenden Signals mit niedriger Frequenz verbessert das elektromagnetische Abstrahlverhalten der Vorrichtung wie bereits weiter oben erläutert wurde. Zuführungsleitungen zwischen dem Signalgenerator und der Berührelektrode können somit auch ohne nachteilige Auswirkung auf das Abstrahlverhalten länger ausgelegt sein, so dass die Berührelektrode weiter entfernt von dem Signalgenerator bzw. der Recheneinheit (Signalauswertung) angeordnet sein kann, was einen größeren Freiheitsgrad bei der Verwendung der erfindungsgemäßen Vorrichtung bereitstellt. Außerdem hat sich herausgestellt, dass die Phasenbewertung des gefilterten Signals deutlich unempfindlicher gegenüber Störeinflüssen wie z. B. Rauschen ist, so dass sich einerseits eine hohe Detektionsempfindlichkeit erzielen lässt und andererseits eine Rate falsch-positiver Berührungserkennungen (auch als "Ghost Touch" bezeichnet) deutlich reduzieren oder sogar ganz beseitigen lässt. Eine höhere Detektionsempfindlichkeit der Vorrichtung erlaubt zum Beispiel die Verwendung einer dickeren Schutzbeschichtung (z. B. Kunststoffüberzug) der Berührelektrode, um diese noch besser vor mechanischen Einflüssen/Abnutzung zu schützen.

Gemäß einer weiteren vorteilhaften Ausgestaltung des Erfindungsgegenstands ist die Recheneinheit eingerichtet, das gefilterte Signal mittels einer Fourier-Transformation, beispielsweise eine diskrete Fourier-Transformation, lediglich für die vorbestimmte Frequenz des erzeugten Signals auszuwerten. Hierdurch lässt sich einerseits der Rechenaufwand für die Recheneinheit erheblich reduzieren, da eine Phasen- und/oder Amplitudenbestimmung lediglich für eine Frequenz einen Rechenaufwand der Größenordnung O(n) erfordert, wobei n die Anzahl der Abtastungen je Periodenintervall des erzeugten Signals darstellt. Andererseits wird durch die vorliegende Fourier-Transformation aber ebenso eine wirksame Rauschunterdrückung erzielt, da Rauschsignale anderer Frequenzen als die vorbestimmte Frequenz des erzeugten Signals durch die auf die vorstehende Weise ausgeführte Fourier-Transformation verworfen werden.

Die Fourier-Transformation lediglich einer bestimmten Frequenz wirkt wie ein schmalbandiges Filter. Das Band ist hierbei eine Funktion der Anzahl der Abtastungen, die innerhalb einer Periodendauer des erzeugten Signals durchgeführt werden. Insbesondere werden hierdurch elektrostatische Störimpulse (ESD, Electro-Static Discharge) und Injektionsstrompulse (BCI, Bulk Current Injection), deren Frequenzen sicher nicht der Frequenz des erzeugten Signals entsprechen, durch die vorliegende Fourier-Transformation effektiv herausgefiltert, so dass die elektromagnetische Verträglichkeit der erfindungsgemäßen Vorrichtung noch weiter verbessert wird.

Eine noch weitere vorteilhafte Ausgestaltung der Erfindung sieht vor, dass das erzeugte Signal ein Sinussignal ist. Der Signalgenerator erzeugt dementsprechend ein Sinussignal mit vorbestimmter Amplitude und Frequenz. Es ist zu verstehen, dass neben der reinen Sinusform auch andere Signalformen denkbar sind, wobei die Sinusform jedoch eine besonders bevorzugte Variante in Bezug auf die hierin erwähnten vorteilhaften Eigenschaften darstellt.

Das erzeugte Signal kann unabhängig von seiner konkreten Signalform eine Frequenz kleiner oder gleich 100 kHz aufweisen, vorzugsweise kleiner oder gleich 50 kHz, noch bevorzugter kleiner oder gleich 10 kHz. Als bevorzugte Untergrenze für die Frequenz des erzeugten Signals wird eine Frequenz größer oder gleich als 1 kHz angesehen und besonders bevorzugt größer oder gleich 5 kHz, ohne jedoch zwingend auf diese Werte beschränkt zu sein. Somit sind besonders bevorzugte Frequenzbereiche des erzeugten Signals beispielsweise 1 kHz bis 100 kHz oder 1 kHz bis 50 kHz oder 1 kHz bis 10 kHz oder 5 kHz bis 100 kHz oder 5 kHz bis 50 kHz oder 5 kHz bis 10 kHz. Damit liegt die Wellenlänge des erzeugten Signals im Kilometerbereich (z. B. 30 km bei 10 kHz), so dass selbst lange Zuleitungen, auf denen das erzeugte und/oder das gefilterte Signal übertragen werden, bestenfalls als schlechte, ineffiziente Antennen wirken können, so dass die Vorrichtung nur sehr geringe elektromagnetisches Abstrahlung erzeugt. Die Berührelektrode kann zudem verhältnismäßig weit vom Signalgenerator und/oder der Recheneinheit entfernt angeordnet sein, zum Beispiel einige wenige Meter, einige zehn Meter oder sogar bis hundert oder einige wenige hundert Meter.

Weiterhin kann gemäß einer noch anderen vorteilhaften Ausgestaltung der Erfindung die Recheneinheit ferner eingerichtet sein, den Signalgenerator zur Erzeugung des Signals zu steuern. Hierdurch lässt sich eine äußerst präzise Synchronisierung zwischen dem vom Signalgenerator erzeugten Signal und der Auswertung des gefilterten Signals erreichen. Wie bereits weiter oben erwähnt, kann dem Signalgenerator gegebenenfalls über so genannte DMA-Mechanismen ein direkter Zugriff auf eine optionale Speichereinheit der Recheneinheit gewährt werden (z. B. für von der Recheneinheit bereitgestellte Signalparameter), wodurch sich u. a. der Steueraufwand der Recheneinheit verringert.

Der Widerstandswert des ohmschen Widerstands zur Bildung des RC-Filters gemeinsam mit der Kapazität der Berührelektrode kann vorzugsweise größer oder gleich 100 kΩ gewählt werden. Hierdurch lassen sich besonders bevorzugte Filtereigenschaften des RC-Filters für die Berührungsdetektion erreichen, um die hierin erwähnten Vorteile optimal auszureizen.

Eine noch weitere vorteilhafte Ausgestaltung der Erfindung sieht vor, dass die Berührelektrode wenigstens teilweise, bevorzugt vollständig, von einer aktiven Schirmelektrode umgeben ist. "Aktiv" bedeutet, dass die Schirmelektrode nicht statisch einmalig auf ein bestimmtes elektrisches Potenzial eingestellt und gehalten ist, sondern bei der vorliegenden Ausgestaltung mit demselben Signal wie das der Berührelektrode zugeführte Signal beaufschlagt ist. Das heißt, das vom Signalgenerator erzeugte Signal wird ebenfalls der Schirmelektrode zugeführt. Insbesondere kann der Schirmelektrode das erzeugte Signal hierbei unter Umgehung des ohmschen Widerstands unmittelbar zugeführt werden, also ohne Einwirkung des RC-Filters. Die Schirmelektrode kann auch über einen ohmschen Kopplungswiderstand, zum Beispiel im Bereich von einigen 100 kΩ, elektrisch mit der Berührelektrode verbunden sein.

Die aktive Schirmelektrode erzeugt einen niederohmigen Pfad (Vorzugsrichtung) für das von der Berührelektrode ausgehende elektrische Feld hinsichtlich des sich an die Berührelektrode annähernden Objekts. Es ist zwar auch möglich, die Schirmelektrode statisch auf Erdpotenzial (GND) zu legen, jedoch können in diesem Fall zusätzlich parasitäre Kapazitäten zwischen der Berührelektrode und der Schirmelektrode bzw. GND auftreten, die sich nachteilig auf die Detektionsempfindlichkeit auswirken können. Daher ist die aktive Beaufschlagung der Schirmelektrode mit dem vom Signalgenerator erzeugten Signal besonders bevorzugt. Darüber hinaus verhindert die aktive Schirmelektrode selbst bei einer teilweisen oder vollständigen Bedeckung mehrerer benachbarter Berührelektroden mit einer Flüssigkeit, zum Beispiel Wasser, die Bildung parasitärer Kapazitäten zwischen diesen, insbesondere zwischen einer mit dem erzeugten Signal beaufschlagten (aktiven) Berührelektrode und einer nicht mit dem Signal beaufschlagten (passiven) Berührelektrode. Dementsprechend ist es besonders bevorzugt, sowohl die Schirmelektrode als auch die Berührelektrode bzw. mehrere Berührelektroden aktiv mit dem vom Signalgenerator erzeugten Signal zu beaufschlagen.

Gemäß einer noch weiteren vorteilhaften Ausgestaltung der Erfindung sind mehrere Berührelektroden in einer gitterartigen Anordnung mit mehreren Spalten und mit mehreren Zeilen vorgesehen, wobei der Signalgenerator vermittels des ohmschen Widerstands wahlweise mit den (insbesondere allen) Berührelektroden einer der Spalten oder alternativ einer der Zeilen elektrisch gekoppelt ist und die Recheneinheit eingerichtet ist, wahlweise das gefilterte Signal einer der Zeilen bzw. alternativ einer der Spalten zu empfangen und auszuwerten. Die Berührelektroden bilden bei dieser Ausgestaltung ein mehrzeiliges und mehrspaltiges Berührelektrodenfeld, das heißt kein kapazitives Sensorgitter, bei dem sich benachbarte Berührelektroden gegenseitig beeinflussen (auch als "Mutual Capacitance" bezeichnet). Wenn beispielsweise einer der Spalten das erzeugte Signal zugeführt wird, ist eine der Spalten durch Annäherung/Berührung durch das Objekt dann ausgewählt/berührt, wenn eine Abweichung des gefilterten Signals für diese Zeile vorliegt. Befindet sich das ausgewertete, gefilterte Signal der augenblicklichen Zeile z. B. in Phase mit dem ursprünglich erzeugten Signal und/oder ist keine Amplitudenabweichung feststellbar, liegt keine Berührung der Zeile vor. Auf diese Weise können zu je einer aktivierten Spalte alle Zeilen ausgewertet werden. Dieser Vorgang kann für alle Spalten wiederholt werden, so dass schließlich das gesamte Berührelektrodenfeld ausgewertet wird. Die Reihenfolge der Auswertung von Spalten und Zeilen kann selbstverständlich umgekehrt werden.

Erfindungsgemäß ist das vom Signalgenerator erzeugte Signal eine Überlagerung wenigstens zweier Einzelsignale mit unterschiedlicher Frequenz. Zum Beispiel können zwei sinusförmige Einzelsignale mit verschiedenen Frequenzen zu dem der Berührelektrode zugeführten Gesamtsignal überlagert sein. Erfindungsgemäß sind die Frequenzen hierbei derart gewählt, dass an demselben RC-Filter eine der Frequenzen hauptsächlich eine Phasenverschiebung des gefilterten Signals bewirkt und die andere Frequenz in erster Linie eine Amplitudenveränderung. So kann die Berührelektrode mit nur einem einzigen Signal beispielsweise auf ihre bestimmungsgemäße Funktionsfähigkeit getestet werden. Die Auswertung des gefilterten Signals mittels der Recheneinheit erfolgt entsprechend für beide Frequenzen des erzeugten Signals.

Die Berührelektrode kann spiralförmig auf einem Substrat (z. B. Leiterplatte) ausgebildet sein. Die Berührelektrode kann auch vollflächig auf dem Substrat ausgebildet sein. Zum Beispiel kann bei gleicher Substratfläche eine spiralförmige Ausgestaltung der Berührelektrode etwa die Hälfte der Fläche einer vollflächigen Berührelektrode ausmachen. Beide Ausführungen der Berührelektrode zeigen im Wesentlichen dieselben hierin beschriebenen vorteilhaften Eigenschaften.

Gemäß einem weiteren Aspekt der Erfindung wird bei einem Verfahren zur kapazitiven Berührungsdetektion eine Kapazitätsänderung bei Annäherung eines Objekts, zum Beispiel eines Fingers einer Person, an wenigstens eine Berührelektrode, die eine Kapazität aufweist, erfasst, wobei ein vorbestimmtes periodisches Signal mit vorbestimmter Frequenz und Phase erzeugt wird und der Berührelektrode elektrisch zugeführt wird. Das erzeugte Signal wird der Berührelektrode hierbei vermittels eines ohmschen Widerstands derart zugeführt, dass der Widerstand und die Kapazität der Berührelektrode bezüglich des der Berührelektrode zugeführten Signals ein RC-Filter bilden, durch welches das der Berührelektrode zugeführte erzeugte Signal gefiltert wird. Eine Abweichung des gefilterten Signals gegenüber dem erzeugten Signal wird ausgewertet.

Es sei darauf hingewiesen, dass bezüglich verfahrensbezogener Begriffsdefinitionen sowie der Wirkungen und Vorteile verfahrensgemäßer Merkmale vollumfänglich auf die vorstehenden Erläuterungen sinngemäßer Definitionen, Wirkungen und Vorteile bezüglich der erfindungsgemäßen Vorrichtung verwiesen wird. Offenbarungen hierin bezüglich des erfindungsgemäßen Verfahrens sollen in sinngemäßer Weise auch zur Definition der erfindungsgemäßen Vorrichtung herangezogen werden können, sofern dies hierin nicht ausdrücklich ausgeschlossen ist. Ebenso sollen Offenbarungen hierin bezüglich der erfindungsgemäßen Vorrichtung in sinngemäßer Weise zur Definition des erfindungsgemäßen Verfahrens herangezogen werden können, sofern dies hierin nicht ebenfalls ausdrücklich ausgeschlossen ist. Insofern kann auf eine Wiederholung von Erläuterungen sinngemäß gleicher Merkmale, deren Wirkungen und Vorteile bezüglich der hierin offenbarten erfindungsgemäßen Vorrichtung sowie des hierin offenbarten erfindungsgemäßen Verfahrens zugunsten einer kompakteren Beschreibung weitgehend verzichtet werden.

Das erzeugte Signal kann beispielsweise ein Sinussignal mit vorbestimmter Frequenz und Amplitude sein, ohne jedoch zwingend auf die Sinusform beschränkt zu sein.

Besonders bevorzugte Frequenzen des erzeugten Signals liegen im Kilohertz-Bereich, zum Beispiel kleiner oder gleich 100 kHz, noch bevorzugter kleiner oder gleich 50 kHz, z. B. kleiner oder gleich 10 kHz. Als bevorzugte Untergrenze für die Frequenz des erzeugten Signals wird eine Frequenz größer oder gleich als 1 kHz angesehen und besonders bevorzugt größer oder gleich 5 kHz, ohne jedoch zwingend auf diese Werte beschränkt zu sein. Somit sind besonders bevorzugte Frequenzbereiche des erzeugten Signals beispielsweise 1 kHz bis 100 kHz oder 1 kHz bis 50 kHz oder 1 kHz bis 10 kHz oder 5 kHz bis 100 kHz oder 5 kHz bis 50 kHz oder 5 kHz bis 10 kHz.

Die Erzeugung des Signals kann mittels eines (digitalen) Signalgenerators durchgeführt werden.

Die Auswertung des gefilterten Signals kann mittels einer Recheneinheit, z. B. Mikrocontroller, durchgeführt werden.

Gemäß einer vorteilhaften Ausgestaltung der Erfindung wird das erzeugte Signal zuerst durch den ohmschen Widerstand geleitet, bevor es der Berührelektrode zugeführt wird, so dass eine Reihenschaltung aus dem ohmschen Wiederstand und der Kapazität der Berührelektrode gebildet wird, die auf das zugeführte Signal als RC-Tiefpassfilter wirkt.

Nach einer besonders bevorzugten Weiterbildung des Erfindungsgegenstands wird eine elektrische Spannung des gefilterten Signals (d. h. eine ausgangsseitige Spannung des RC-Filters) ausgewertet.

Weiterhin sieht eine andere Ausgestaltung der Erfindung vor, dass eine Phasenverschiebung des gefilterten Signals gegenüber dem erzeugten Signal als die Abweichung ausgewertet wird. Die Auswertung der Signalamplitude des gefilterten Signals ist hierbei zwar nicht zwingend ausgeschlossen, es kann jedoch besonders bevorzugt sein, die Auswertung lediglich auf die Phasenverschiebung zu beschränken, da sich hierdurch das Verfahren vereinfacht und Rechenressourcen einer Auswerteeinheit (z. B. Mikrocontroller) eingespart werden können.

Gemäß einer noch weiteren vorteilhaften Ausgestaltung der Erfindung wird der Berührelektrode das erzeugte Signal kontinuierlich zugeführt, während das gefilterte Signal ausgewertet wird. Hierdurch wird ein der Berührelektrode zugeführtes niederohmiges Signal bereitgestellt.

In vorteilhafter Weiterbildung des Erfindungsgegenstands wird das gefilterte Signal mittels einer Fourier-Transformation lediglich für die vorbestimmte Frequenz des erzeugten Signals ausgewertet.

Weiterhin kann einer die Berührelektrode wenigstens teilweise umgebende, aktive Schirmelektrode dasselbe erzeugte Signal wie für die Berührelektrode zugeführt werden.

Werden mehrere Berührelektroden bereitgestellt, die gitterartig in mehreren Spalten und in mehreren Zeilen angeordnet werden können, wird diesen das erzeugte Signal vermittels des ohmschen Widerstands bevorzugt derart zugeführt, dass wahlweise den Berührelektroden einer der Spalten oder (alternativ) einer der Zeilen das erzeugte Signal zugeführt wird und das gefilterte Signal der Zeilen bzw. (alternativ) der Spalten nacheinander ausgewertet wird.

Erfindungsgemäß wird das erzeugte Signal als eine Überlagerung wenigstens zweier Einzelsignale mit unterschiedlicher Frequenz gebildet. Erfindungsgemäß sind die Frequenzen hierbei derart gewählt, dass an dem RC-Filter eine der Frequenzen hauptsächlich eine Phasenverschiebung des gefilterten Signals bewirkt und die andere Frequenz in erster Linie eine Amplitudenveränderung.

Gemäß einer noch weiteren vorteilhaften Ausgestaltung der Erfindung kann ein Durchschnittswert abgetasteter Signalwerte des empfangenen gefilterten Signals ermittelt werden und zum Beispiel für die Auswertung der Phasenverschiebung gegenüber dem ursprünglich erzeugten Signal herangezogen werden. Eine Amplitudenauswertung ist auf diese Weise ebenfalls möglich. Die Durchschnittsfilterung verringert die Streuung/Varianz der empfangenen Signalwerte um den Faktor $1/\sqrt{n}$, wobei $n$ die Anzahl der berücksichtigten Abtastwerte ist. So lässt sich auf diese Weise beispielsweise mit 16 Abtastwerten die Streuung der Signalmesswerte um ¼ reduzieren.

Ein optimaler Grenzwert für eine Entscheidung zwischen einem wahr-positiven Berührereignisses und einem falsch-positiven Berührereignisses (Ghost Touch) kann wie folgt bestimmt werden.

Bei gleicher Bewertung eines wahr-positiven Berührereignisses und eines falsch-positiven Berührereignisses wird der optimale Grenzwert Th bevorzugt wie folgt bestimmt:

$$Th = (Durchschnitts\text{-}Signal\text{-}Nulllinie + Durchschnitts\text{-}Berührsignal) \: / \: 2$$

Ein Berührereignis wird dann fälschlicherweise (Ghost Touch) als wahr-positives Berührereignis bewertet, wenn das falsch-positive Berührsignal größer ist als der zuvor definierte Grenzwert *Th*. Die Wahrscheinlichkeit für ein falsch-positiv bewertetes Berührereignis ist proportional zum Signal-Rausch-Verhältnis *SNR*, wobei

$$SNR = (Th - Durchschnitt\text{-}Signal\text{-}Nulllinie) \: / \: Varianz$$

Damit ergeben sich beispielhaft die folgenden Werte:

| SNR | 1 | 2 | 3 | 4 | 5 | 6 |
|---|---|---|---|---|---|---|
| | 0.158655 | 0.02275 | 0.00135 | 3.17E-05 | 2.87E-07 | 9.87E-10 |

Gemäß einem weiteren Aspekt er Erfindung weist ein Lenkrad für ein Kraftfahrzeug wenigstens einen eine elektrische Widerstandsheizung bildenden Heizleiter, der einen ohmschen Widerstand R aufweist, sowie eine Vorrichtung zur kapazitiven Berührungsdetektion in einer Detektionsbetriebsart auf, insbesondere zur Hands-On-Erkennung, wobei dem Heizleiter in einer Heizbetriebsart mittels wenigstens eines steuerbaren Schaltelements (z. B. Transistor) wahlweise elektrische Energie aus einer Energiequelle (z. B. Batterie) zuführbar ist und die Vorrichtung nach einer der hierin offenbarten Ausgestaltungen ausgebildet ist. Erfindungsgemäß bildet der Heizleiter der Widerstandsheizung gleichzeitig auch die Berührelektrode mit Kapazität C der Vorrichtung zur Berührdetektion, so dass der RC-Filter nur aus dem wenigstens einen Heizleiter gebildet ist. Das heißt, der Heizleiter und die Berührelektrode bzw. der RC-Filter sind durch ein und dasselbe Bauteil gebildet, nämlich den wenigstens einen Heizleiter. Die Erfindung sieht weiter vor, dass die Heizbetriebsart der Widerstandsheizung und die Detektionsbetriebsart der Vorrichtung zur Berührungsdetektion periodisch alternierend geschaltet sind. Mit anderen Worten sind die Heizbetriebsart und die Detektionsbetriebsart nicht gleichzeitig aktiv, sondern werden nach Art eines Zeitmultiplex-Schemas alternierend aktiviert. Es ist demnach periodisch ein Zeitfenster zur Aktivierung der Heizbetriebsart (sofern eine Heizbetriebsart beispielsweise durch einen Benutzer angefordert ist) und ein Zeitfenster zur Aktivierung der Berührungsdetektion vorgesehen.

Das wenigstens eine Schaltelement kann als an sich wohl bekannter Transistorschalter ausgebildet sein, wobei dieser vorzugsweise eine möglichst niedrige parasitäre Kapazität aufweist. Derartige Halbleiterschalter werden auch als High-Side- bzw. Low-Side-Schalter bezeichnet. Bevorzugt ist der wenigstens eine Heizleiter der Widerstandsheizung beidseitig über jeweils ein Schaltelement von der Energiequelle, die z. B. eine Fahrzeugbatterie sein kann, elektrisch trennbar bzw. elektrisch mit dieser verbindbar. Gewöhnlich weisen die Schaltelemente parasitäre Kapazitäten im Bereich von etwa 100 Pikofarad (pF) oder mehr bis ein oder einige wenige (einstellig) Nanofarad (nF) auf, z. B. etwa 100 pF bis 1 nF oder 200 pF bis etwa 500 pF. Der wenigstens eine Heizleiter kann beispielsweise einen ohmschen Widerstand von einem oder einigen wenigen Ohm, z. B. 1 Ω bis 5 Ω oder 2 Ω bis 4 Ω, aufweisen sowie eine elektrische Kapazität von etwa 50 pF bis 300 pF, bevorzugter etwa 100 pF bis 250 pF.

Insgesamt weist die Anordnung aus dem wenigstens einen Heizleiter der Widerstandsheizung und dem wenigstens einen (bevorzugt zwei) Schaltelement zum Schalten der Widerstandsheizung Kapazitätswerte auf, die deutlich über den Werten herkömmlicher kapazitiver Berührfolien liegen. Letztere weisen gewöhnlich Kapazitätswerte im niedrigen pF-Bereich auf, z. B. 1 pF bis 10 pF oder einige wenige (einstellige) Vielfache hiervon, und liegen damit durchaus um einen Faktor 10 bis 1000 unterhalb der Kapazitätswerte, die das erfindungsgemäße Lenkrad mit der Widerstandsheizung aufweist.

In vorteilhafter Weise ist die hierin offenbarte erfindungsgemäße Vorrichtung zur Berührungsdetektion dazu ausgebildet, auch in diesem wesentlich größeren Kapazitätsbereich eine Annäherung bzw. Berührung des Berührungssensors (d. h. des wenigstens einen Heizleiters) zuverlässig und genau durchzuführen.

Es ist zu verstehen, dass bezüglich der lenkradbezogenen Begriffsdefinitionen sowie der Wirkungen und Vorteile lenkradgemäßer Merkmale vollumfänglich auf die Offenbarung sinngemäßer Definitionen, Wirkungen und Vorteile des erfindungsgemäßen Verfahrens und der erfindungsgemäßen Vorrichtung zur Berührungsdetektion zurückgegriffen werden kann und umgekehrt, so dass an dieser Stelle auf eine Wiederholung von Erläuterungen sinngemäß gleicher Merkmale, deren Wirkungen und Vorteile zugunsten einer kompakteren Beschreibung verzichtet wird, ohne dass derartige Auslassungen als Einschränkung auszulegen wären.

Gemäß einer vorteilhaften Weiterbildung des Erfindungsgegenstands weist das Lenkrad einen metallischen Lenkradkern auf, der mit einem vorherbestimmten elektrischen Potential beaufschlagt ist oder potentialfrei gehalten ist. Das vorherbestimmte elektrische Potential ist bevorzugt ein gemeinsames Bezugspotenzial der Vorrichtung zur Berührungsdetektion sowie der Widerstandsheizung und kann einem in Fahrzeugen üblicherweise bereitgestellten Massepotential (GND) entsprechen.

Die elektrische Kopplung des metallischen Lenkradkerns an das vorherbestimmte Bezugspotential kann unmittelbar erfolgen, das heißt ohne Zwischenschaltung zusätzlicher aktiver oder passiver elektronischer Bauelemente. Die elektrische Kopplung kann auch unter Zwischenschaltung eine Kapazität erfolgen, die bevorzugt Kapazitätswerte im Bereich von etwa 10 nF bis 1 μF aufweisen kann.

Alternativ kann der Lenkradkern auch potentialfrei gehalten sein, das heißt er weist gar keine elektrische Verbindung bzw. Kopplung zu einem vorherbestimmten elektrischen Potential auf. Überraschender Weise hat sich herausgestellt, dass eine derartige potentialfreie Anordnung des metallischen Lenkradkerns die zuverlässige Berührungsdetektion noch deutlich verbessern kann, insbesondere in Bezug auf eine höhere Empfindlichkeit der Berührungsdetektion sowie eine geringere Beeinflussung durch Rauschen. Diese Ausgestaltung ist daher besonders bevorzugt.

Eine andere vorteilhafte Ausgestaltung der Erfindung sieht vor, dass die Widerstandsheizung wenigstens fünf, bevorzugt wenigstens zehn Heizleiter aufweist. Auch in diesem Fall hat sich gezeigt, dass eine noch weitere Verbesserung der Detektionsfähigkeit erzielbar ist.

Zusätzlich oder alternativ kann auch über das Gütekriterium (Q-Faktor) der für die Berührungsdetektion relevanten elektrischen Komponenten (z. B. Schaltelement/e) und/oder über die Frequenz des vorbestimmten periodischen Signals Einfluss auf die Qualität der Berührungsdetektion genommen werden, wobei sich gezeigt hat, dass ein größerer Q-Faktor (z. B. etwa 3-5 anstelle von 1-1,5) und/oder eine höhere Frequenz (z. B. 20 kHz bis 30 kHz anstelle von 5-10 kHz) eine weitere Verbesserung in Bezug auf die Zuverlässigkeit und Empfindlichkeit der Berührungsdetektion erzielen.

Weitere Merkmale und Vorteile der Erfindung ergeben sich aus der folgenden Beschreibung eines nicht einschränkend zu verstehenden Ausführungsbeispiels der Erfindung, die im Folgenden unter Bezugnahme auf die Zeichnung näher erläutert wird. In dieser Zeichnung zeigen schematisch:

Fig. 1        ein Ausführungsbeispiel einer Vorrichtung zur kapazitiven Berührungsdetektion gemäß der Erfindung,

Fig. 2        einen Amplitudenverlauf einer Filterantwort eines RC-Filters erster Ordnung,

Fig. 3        einen Phasenverlauf einer Filterantwort eines RC-Filters erster Ordnung,

Fig. 4        eine erste Verwendung eines weiteren Ausführungsbeispiels einer Vorrichtung zur kapazitiven Berührungsdetektion gemäß der Erfindung,

Fig. 5        eine zweite Verwendung der Vorrichtung aus Fig. 4,

Fig. 6        eine Betriebssituation der Vorrichtung aus Fig. 4 in ihrer ersten Verwendung,

Fig. 7        die Betriebssituation der Vorrichtung aus Fig. 6 in einer dritten Verwendung,

Fig. 8        ein erstes Ausführungsbeispiel einer Berührelektrode,

Fig. 9        ein zweites Ausführungsbeispiel einer Berührelektrode,

Fig. 10      ein Ausführungsbeispiel einer Anordnung mehrerer Berührelektroden und

Fig. 11      in einer Ausschnittansicht ein Ausführungsbeispiel eines Lenkrads für ein Kraftfahrzeug.

In den unterschiedlichen Figuren sind hinsichtlich ihrer Funktion gleichwertige Teile stets mit denselben Bezugszeichen versehen, so dass diese in der Regel auch nur einmal beschrieben werden.

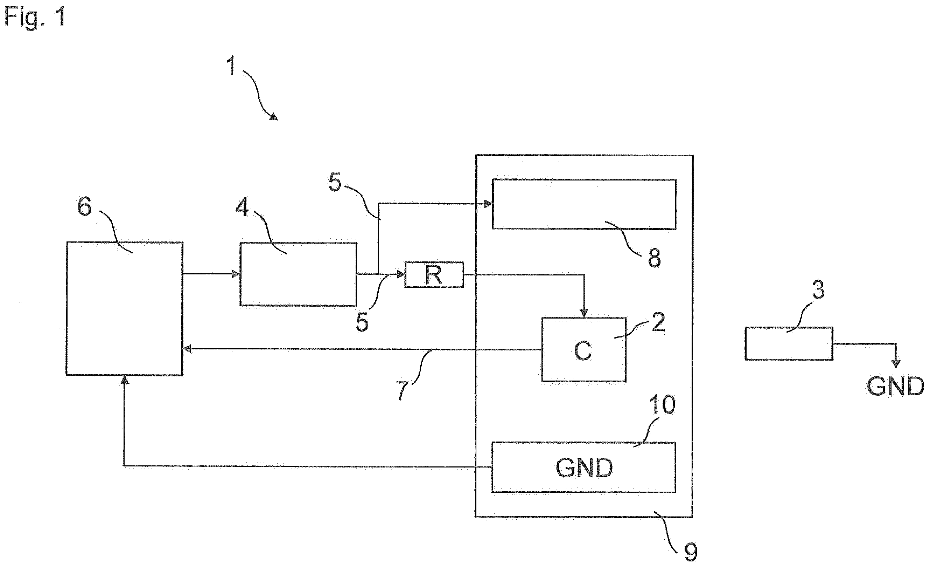

Fig. 1 stellt schematisch ein Ausführungsbeispiel einer Vorrichtung 1 zur kapazitiven Berührungsdetektion gemäß der Erfindung dar. Wie Fig. 1 zu entnehmen ist, weist die Vorrichtung 1 eine Berührelektrode 2 (es können in anderen Ausführungsbeispielen auch mehrere Berührelektroden 2 bereitgestellt sein) mit einer Kapazität C zur Erfassung einer Kapazitätsänderung bei Annäherung eines Objekts 3, zum Beispiel ein Finger einer Person (nicht dargestellt), an die Berührelektrode 2, einen Signalgenerator 4 zur Erzeugung wenigstens eines vorbestimmten periodischen Signals 5, vorliegend ohne Beschränkung ein sinusförmiges Signal, mit vorbestimmter Frequenz und Phase, das der Berührelektrode 2 elektrisch zugeführt ist, und eine elektronische Recheneinheit 6, vorliegend als Mikrocontroller einschließlich einer Speichereinheit (nicht separat dargestellt) ausgeführt, auf.

Das vom Signalgenerator erzeugte Signal 5 weist bevorzugt eine Frequenz kleiner oder gleich 100 kHz auf, vorzugsweise kleiner oder gleich 50 kHz, noch bevorzugter kleiner oder gleich 10 kHz. Als besonders bevorzugte Untergrenze wird eine Frequenz größer oder gleich 1 kHz, noch bevorzugter größer oder gleich 5 kHz angesehen.

Fig. 1 ist weiter zu entnehmen, dass der Signalgenerator 4 vermittels eines ohmschen Widerstands R mit der Berührelektrode 2 elektrisch gekoppelt ist. Insbesondere bilden der Widerstand R und die Kapazität C der Berührelektrode 2 der Vorrichtung 1 bezüglich des der Berührelektrode 2 zugeführten Signals 5 ein RC-Filter, das das zugeführte Signal 5 filtert und eine gefilterte elektrische Spannung eines gefilterten Signals 7 (d. h. Ausgangsspannung des RC-Filters) erzeugt. Die Recheneinheit 6 ist eingerichtet, das von dem RC-Filter gefilterte Signal 7 zu empfangen und eine Abweichung des gefilterten Signals 7 gegenüber dem erzeugten Signal 5 auszuwerten. Die Recheneinheit 6 wertet vorliegend eine elektrische Spannung des gefilterten Signals 7 aus.

Ein Widerstandswert des ohmschen Widerstands R ist bevorzugt größer oder gleich 100 kΩ.

Weiterhin sind bei der Vorrichtung 1 ein das erzeugte Signal 5 bereitstellender, in Fig. 1 nicht separat gekennzeichneter Ausgang des Signalgenerators 4, der Widerstand R und die Berührelektrode C in Reihe geschaltet. Dementsprechend weist der RC-Filter in Bezug auf die Signalauswertung, d. h. den Vergleich des dem RC-Filter eingangsseitig zugeführten Signals (d. h. eingangsseitige Signalform) und des vom RC-Filter ausgegebenen, gefilterten Signals (d. h. ausgangsseitige Signalform), Tiefpasseigenschaften auf.

Ferner ist die Recheneinheit in dem in Fig. 1 dargestellten Beispiel ferner eingerichtet, den Signalgenerator 4 zur Erzeugung des Signals 5 zu steuern, ohne jedoch zwingend hierauf beschränkt zu sein. Hierzu kann der Signalgenerator 4 das zu erzeugende Signal 5 beschreibende Signalparameter von der Recheneinheit 6 beziehen. Die Signalparameter können hierzu in der Speichereinheit der Recheneinheit 6 gespeichert sein. Ein Zugriff von dem Signalgenerator 4 auf die Speichereinheit der Recheneinheit 6 kann über DMA erfolgen, ohne jedoch zwingend hierauf beschränkt zu sein.

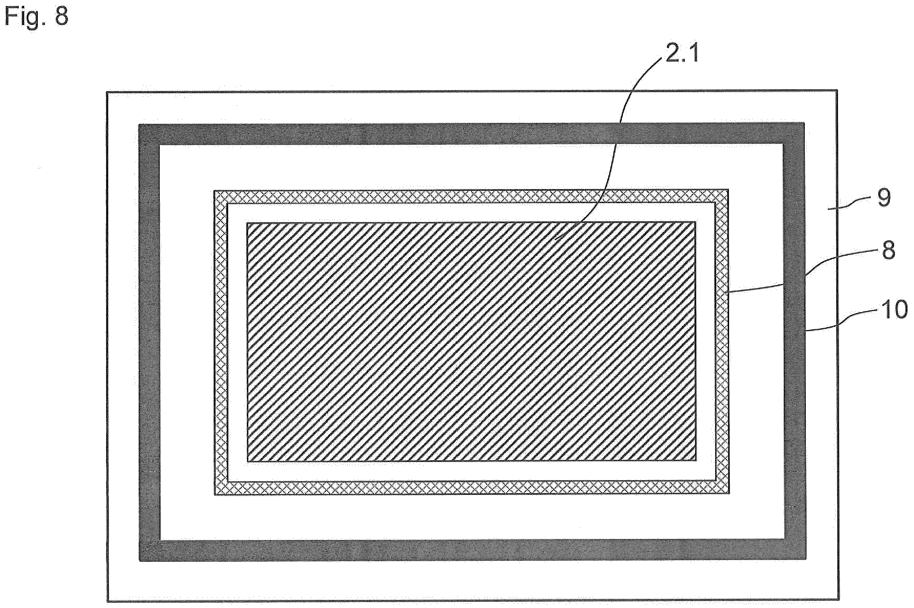

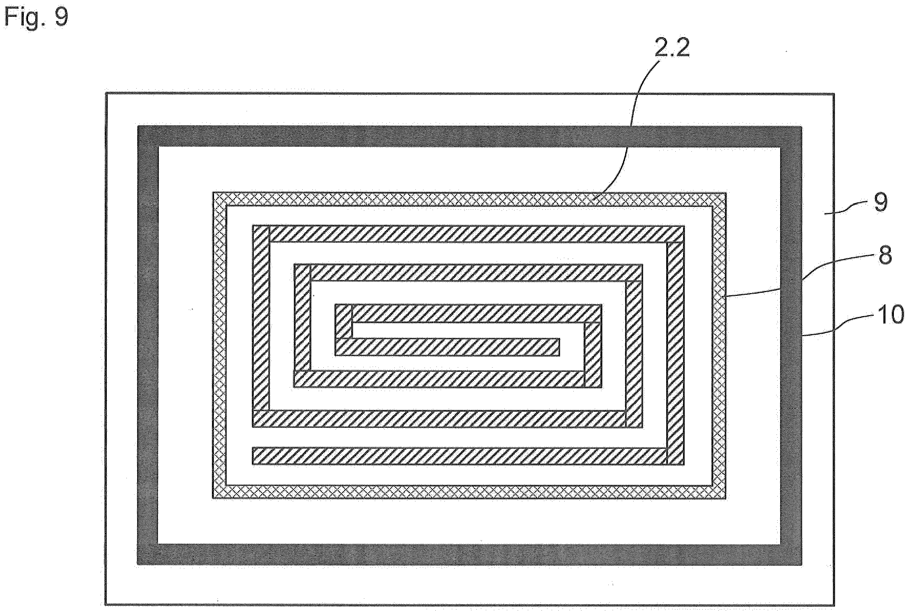

Die Vorrichtung 1 aus Fig. 1 weist ebenfalls eine aktive Schirmelektrode 8 auf, ohne jedoch zwingend hierauf beschränkt zu sein. Die Schirmelektrode 8 umgibt vorliegend die Berührelektrode 2, was deutlicher in den Fig. 8 und 9 zu erkennen ist. In Fig. 1 ist zu erkennen, dass dasselbe vom Signalgenerator 4 erzeugte Signal 5 sowohl der Berührelektrode 2 als auch der Schirmelektrode 8 zugeführt ist und beide somit stets dasselbe elektrische Potential aufweisen.

Fig. 1 ist weiterhin zu entnehmen, dass die Berührelektrode 2 und die Schirmelektrode 8 gemeinsam auf einer Sensorfolie 9 angeordnet sind, ohne jedoch zwingend hierauf beschränkt zu sein. Auf dieser ist vorliegend ferner eine Erdungselektrode 10 angeordnet, ohne jedoch zwingend hierauf beschränkt zu sein. Die Erdungselektrode 10, die Recheneinheit 6 und das Objekt 3 (z. B. Finger einer Person) sind auf ein gemeinsames Bezugspotenzial GND (Erdpotenzial) bezogen.

Die Recheneinheit 6 der beispielhaften Vorrichtung 1 wertet als Abweichung des gefilterten Signals 7 gegenüber dem erzeugten Signal 5 eine Phasenverschiebung aus, ohne jedoch zwingend hierauf beschränkt zu sein. Alternativ oder zusätzlich kann die Recheneinheit 6 eine Abweichung der Amplitude des gefilterten Signals 7 gegenüber dem erzeugten Signal 5 detektieren.

Hierzu ist die Recheneinheit 6 ferner eingerichtet, das gefilterte Signal 7 mittels einer Fourier-Transformation auszuwerten. Insbesondere wird die Fourier-Transformation vorliegend lediglich für die vorbestimmte Frequenz des erzeugten Signals 5 ermittelt.

Zur Auswertung durch die Recheneinheit 6 wird der Berührelektrode 2 das erzeugte Signal 5 kontinuierlich zugeführt. Das gefilterte Signal 7 wird währenddessen von der Recheneinheit 6 ausgewertet.

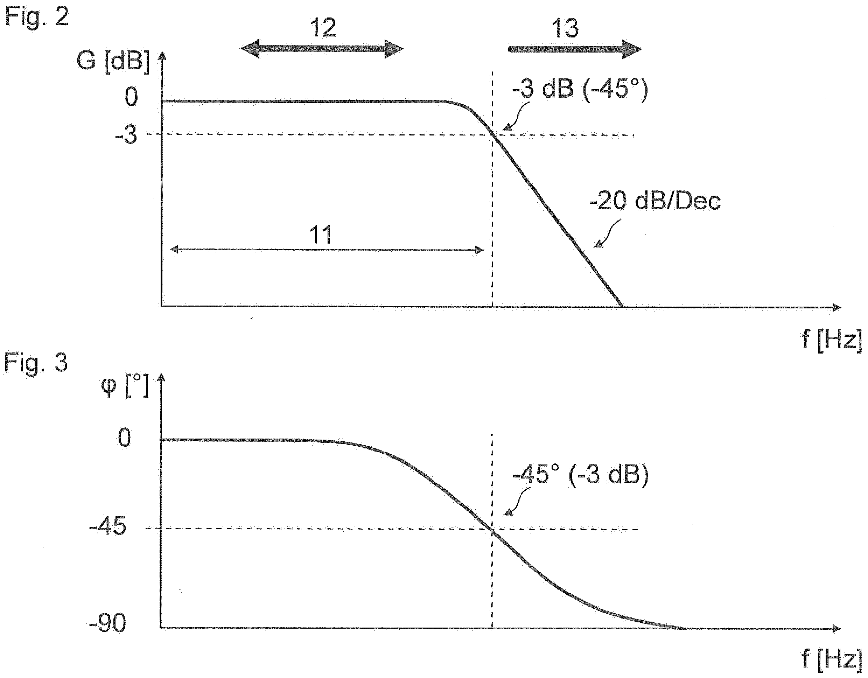

Fig. 2 stellt einen Amplitudenverlauf G(f) einer Filterantwort des RC-Filters erster Ordnung der Vorrichtung 1 aus Fig. 1 in einem logarithmischen Maßstab dar. Diesem ist eine durch das RC-Filter bewirkte Amplitudenänderung abhängig von der Frequenz f zu entnehmen. Eine Bandbreite des RC-Filters ist in Fig. 2 mit 11 gekennzeichnet, die zugleich das Durchlassband 12 des RC-Filters kennzeichnet, im Gegensatz zum Sperrband 13.

Fig. 3 stellt einen Phasenverlauf φ(f) einer Filterantwort des RC-Filters erster Ordnung der Vorrichtung 1 aus Fig. 1 in einem logarithmischen Maßstab dar. Diesem Diagramm ist die durch das RC-Filter bewirkte Phasenverschiebung abhängig von der Frequenz f zu entnehmen.

Ein Vergleich der Fig. 2 und 3 ergibt, dass die Phasenverschiebung bereits bei viel kleineren Frequenzen f einsetzt als die Amplitudenänderung.

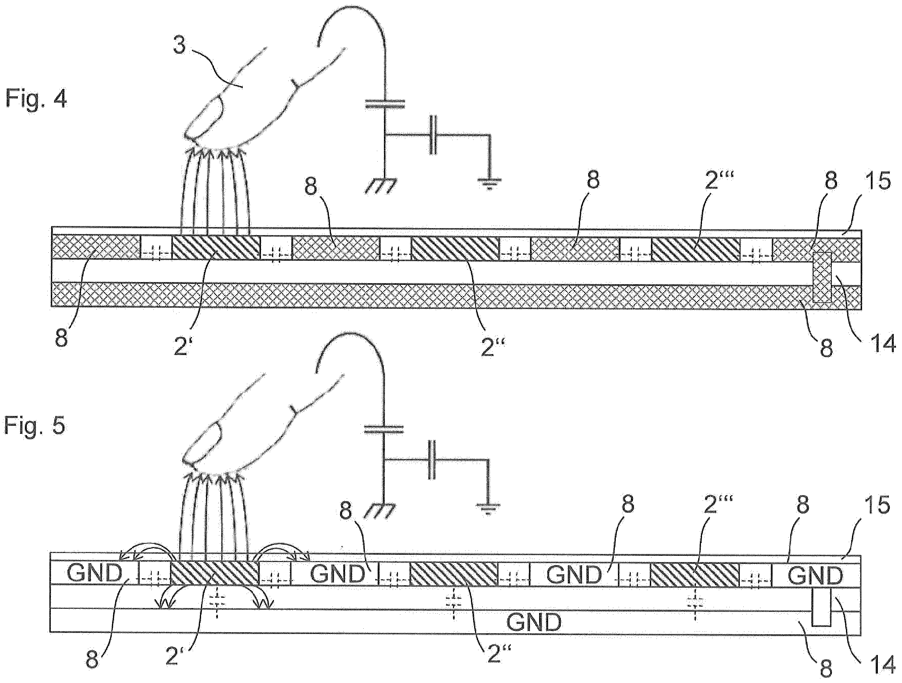

Fig. 4 stellt eine erste Verwendung eines weiteren Ausführungsbeispiels einer Vorrichtung zur kapazitiven Berührungsdetektion gemäß der Erfindung dar, wobei in Fig. 4 lediglich eine Anordnung von mehreren Berührelektroden 2', 2", 2‴ auf einem gemeinsamen Sensorsubstrat 14, das vorliegend als Leiterplatte ausgebildet ist, dargestellt ist. Die Vorrichtung gemäß Fig. 4 kann ansonsten im Wesentlichen dieselben Komponenten und denselben Aufbau aufweisen wie die Vorrichtung 1 aus Fig. 1.

Wie Fig. 4 zu entnehmen ist, sind die auf einer Oberseite der Leiterplatte 14 angebrachten Berührelektroden 2', 2", 2‴ benachbart zueinander angeordnet, wobei sie jeweils von einer Schirmelektrode, zum Beispiel die Schirmelektrode 8 aus Fig. 1, auf der Leiterplattenoberseite umgeben sind. Die Schirmelektrode 8 erstreckt sich bei dem vorliegend dargestellten Beispiel ebenso vollflächig auf die Unterseite der Leiterplatte 14. Oberseitig sind die Berührelektroden 2', 2", 2‴ sowie die umgebenden Schirmelektrode 8 von einer aus einem Kunststoffmaterial gebildeten, oberseitig aufgetragenen Schutzbeschichtung 15 bedeckt. Die Schirmelektrode 8 ist, wie bereits zur Vorrichtung 1 aus Fig. 1 erwähnt, eine aktive Schirmelektrode, die mit demselben erzeugten Signal 5 beaufschlagt ist, wie die Berührelektroden 2', 2", 2‴. Hierdurch wird ein niederohmiger Pfad, das heißt eine Vorzugsrichtung, für das in Fig. 4 von der Berührelektrode 2' ausgehende elektrische Feld zum sich annähernden Finger 3 erzeugt. Unerwünschte zusätzliche parasitäre Kapazitäten werden bei dieser Konfiguration im Wesentlichen vermieden, so dass eine maximale Detektionsempfindlichkeit zur Verfügung steht.

Demgegenüber stellt Fig. 5 eine zweite Verwendung der Vorrichtung aus Fig. 4 dar, bei der die Schirmelektrode 8 fest auf Erdpotenzial GND gelegt ist. Hierdurch stellen sich zusätzliche parasitäre Kapazitäten zwischen der Berührelektrode 2' und der Schirmelektrode 8 ein, die unerwünschte "Kurzschlüsse" für das von der Berührelektrode 2' ausgehende elektrische Feld darstellen, wodurch das zur eigentlichen Berührungsdetektion nutzbare gefilterte Signal 7 abgeschwächt wird. Dies ist in Fig. 5 durch zusätzliche von der Berührelektrode 2' zum Erdpotenzial GND gerichtete Pfeile angedeutet.

Die Ausführung nach Fig. 4 stellt im Vergleich zu Fig. 5 somit eine besonders bevorzugte Ausführung der Vorrichtung zur Berührungsdetektion dar, obwohl die Ausführung nach Fig. 5 nicht zwingend ausgeschlossen ist.

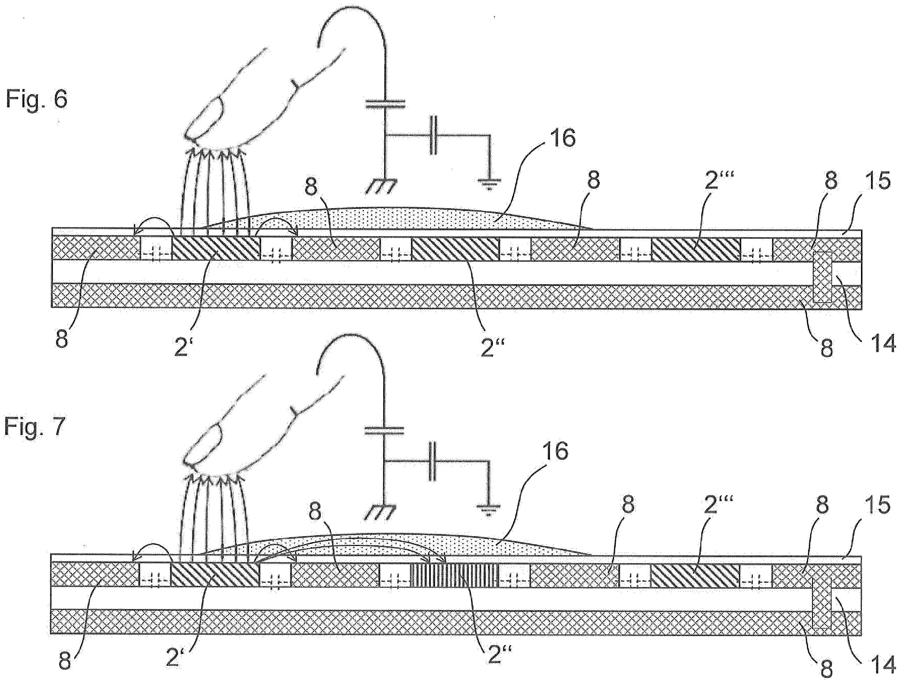

Fig. 6 stellt eine Betriebssituation der Vorrichtung aus Fig. 4 in ihrer ersten Verwendung dar. Die Oberseite der Schutzbeschichtung 15 ist in dieser Situation mit einem Wassertropfen 16 teilweise benetzt. Der Wassertropfen 16 erstreckt sich über einen Teil der Berührelektrode 2' bis über die Berührelektrode 2" hinaus und überdeckt zudem die zwischen diesen beiden Elektroden angeordnete aktive Schirmelektrode 8. In der in Fig. 6 dargestellten ersten Betriebssituation sind alle Berührelektroden 2', 2", 2‴ sowie die aktive Schirmelektrode 8 mit demselben erzeugten Signal 5 beaufschlagt. Der Wassertropfen 16 vermag im Wesentlichen keine zusätzlichen parasitären Kapazitäten zwischen der Berührelektrode 2' und ihrer benachbarten Elektrode 2" zu erzeugen.

Demgegenüber stellt Fig. 7 die Betriebssituation der Vorrichtung aus Fig. 6 in einer dritten Verwendung dar. In diesem Fall ist die Berührelektrode 2" nicht aktiv, das heißt sie wird in der dargestellten Situation nicht mit dem vom Signalgenerator 4 erzeugten Signal 5 beaufschlagt. Infolgedessen ergeben sich durch den Wassertropfen 16 zusätzliche parasitäre Kapazitäten zwischen der aktiven Berührelektrode 2' und der inaktiven Berührelektrode 2", wie dies in Fig. 7 durch entsprechende zusätzliche Pfeile angedeutet ist.

Aus dem Vergleich der Fig. 6 und 7 folgt, dass bei gleichzeitiger Beaufschlagung aller Berührelektroden (sofern mehrere vorhanden sind) sowie der Schirmelektrode 8 mit demselben vom Signalgenerator 4 erzeugten Signal 5 das auswertbare gefilterte Signal 7 maximal ist und eine maximale Detektionsempfindlichkeit gewährleistet. Somit stellt Fig. 6 eine besonders bevorzugte Ausführung der Erfindung dar, obwohl die Ausführung nach Fig. 7 nicht zwingend ausgeschlossen ist.

Fig. 8 stellt ein erstes Ausführungsbeispiel einer Berührelektrode 2.1 dar. Die Berührelektrode 2.1 ist als vollflächige Elektrode ausgebildet und zusammen mit einer die Elektrode 2.1 umgebenden aktiven Schirmelektrode 8 sowie einer die aktive Schirmelektrode 8 wiederum umgebende Erdungselektrode 10 auf einer Sensorfolie 9 angeordnet. Der zwischen der Schirmelektrode 8 und der Berührelektrode 2.1 wirksame ohmsche Widerstand R (vgl. Fig. 1) beträgt bei diesem Ausführungsbeispiel 470 kΩ.

Fig. 9 stellt ein zweites Ausführungsbeispiel einer Berührelektrode 2.2 dar. Die Berührelektrode 2.2 ist als spiralförmige Elektrode ausgebildet und zusammen mit einer die Elektrode 2.2 umgebenden aktiven Schirmelektrode 8 sowie einer die aktive Schirmelektrode 8 wiederum umgebende Erdungselektrode 10 auf einer Sensorfolie 9 angeordnet. Die gesamte Elektrodenfläche der Berührelektrode 2.2 entspricht etwa der Hälfte der vollflächigen Berührelektrode 2.1 aus Fig. 8. Der zwischen der Schirmelektrode 8 und der Berührelektrode 2.2 wirksame ohmsche Widerstand R (vgl. Fig. 1) beträgt bei diesem Ausführungsbeispiel 470 kΩ.

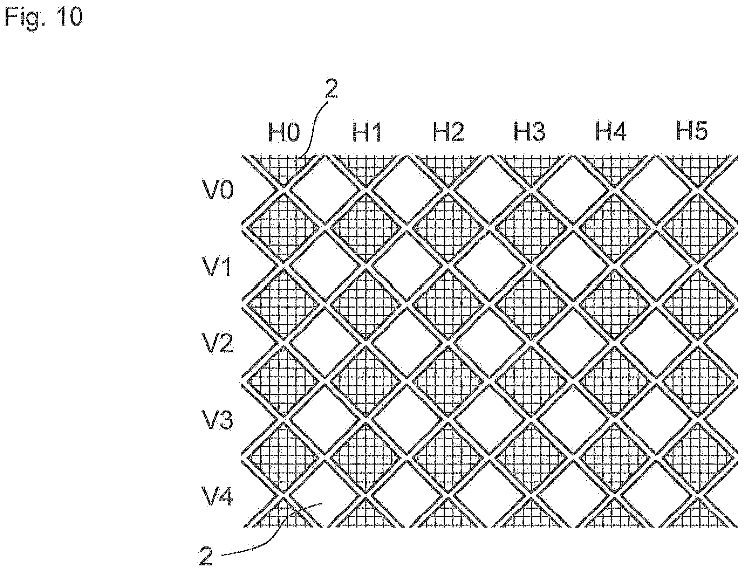

Fig. 10 stellt ein Ausführungsbeispiel einer gitterartigen Anordnung mehrerer Berührelektroden, beispielsweise mehrerer Berührelektroden 2 aus Fig. 1, dar. Die Berührelektroden 2 sind zu mehreren Spalten H0..H5 und zu mehreren Zeilen V0..V4 angeordnet. Die Berührelektroden 2 bilden bei dieser Konfiguration ein mehrzeiliges und mehrspaltiges Berührelektrodenfeld, bei dem sich benachbarte Berührelektroden gegenseitig beeinflussen (auch als "Mutual Capacitance" bezeichnet). Eine Berührungsdetektion kann stattfinden, indem allen Berührelektroden 2 wahlweise einer der Spalten H0..H5 das vom Signalgenerator 4 erzeugte Signal 5 über den Widerstand R zugeführt wird. Die Recheneinheit 6 empfängt das gefilterte Signal 7 wahlweise von einer der Zeilen V0..V4. Weist das empfangene Signal 7 im Wesentlichen keine Abweichung von dem zugeführten Signal 5 auf, wird die entsprechende Zeile nicht berührt. Weist das empfange Signal 7 jedoch eine Abweichung, zum Beispiel Phasenverschiebung, auf, ist die Zeile berührt. Aus der zu diesem Zeitpunkt mit dem zugeführten Signal 5 aktivierten Spalte lässt sich die genaue Koordinate der Berührung auf dem Berührelektrodenfeld ermitteln. Auf diese Weise wird nach dem Auswerten aller Zeilen eine neue Spalte aktiviert und alle Zeilen erneut ausgewertet usw. Es versteht sich, dass Zeilen und Spalten bei der Auswertung auch vertauscht sein können, das heißt das zu je einer Zeile zunächst alle Spalten ausgewertet werden.

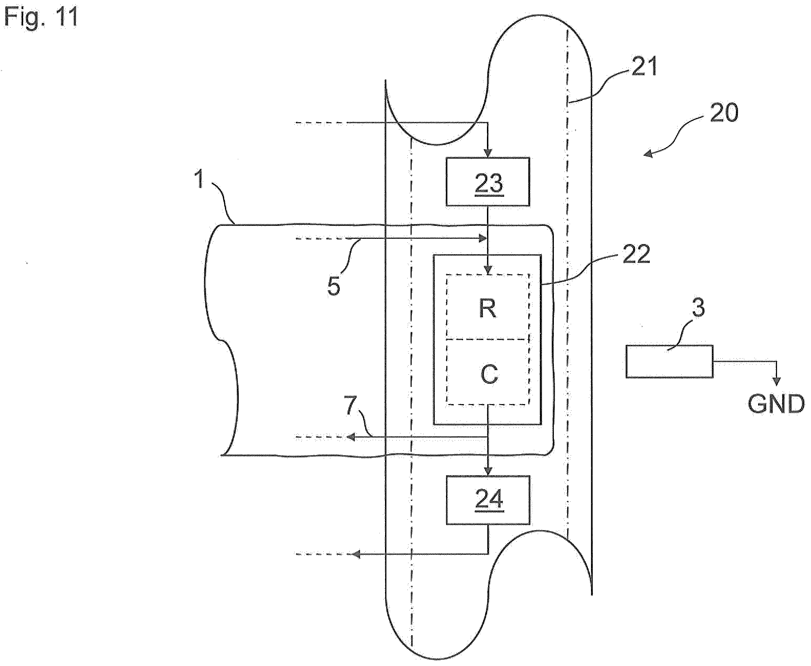

Fig. 11 stellt in einer Ausschnittansicht ein Ausführungsbeispiel eines Lenkrads 20 für ein nicht weiter gezeigtes Kraftfahrzeug dar. Es ist zu erkennen, dass das Lenkrad 20 vorliegend wenigstens einen eine elektrische Widerstandsheizung bildenden Heizleiter 22 mit einem ohmschen Widerstand R aufweist, der in Fig. 11 lediglich schematisch dargestellt ist. Ferner weist das Lenkrad 20 vorliegend eine Vorrichtung zur kapazitiven Berührungsdetektion, z. B. die beispielhafte Vorrichtung 1 aus Fig. 1, auf, wobei eine Berührungsdetektion in einer Detektionsbetriebsart durchgeführt wird. Die Berührungsdetektion dient insbesondere bevorzugt zur so genannten Hands-On-Erkennung, das heißt zur Erkennung, ob ein Fahrer (nicht dargestellt) des Fahrzeugs das Lenkrad 20 mit seiner Hand oder Finger 3 berührt. Dem Heizleiter 22 ist in einer Heizbetriebsart mittels wenigstens eines steuerbaren Schaltelements, vorliegend ein High-Side-Schalter 23 und ein Low-Side-Schalter 24, die vorliegend beispielhaft als Transistoren ausgebildet sind, wahlweise elektrische Energie aus einer Energiequelle (z. B. Fahrzeugbatterie, nicht dargestellt) zuführbar. Die Schaltelemente 23, 24 sind von einer in Fig. 11 nicht gezeigten Steuereinrichtung steuerbar. Diese Steuerfunktion kann beispielsweise von der in Fig. 1 dargestellten Recheneinheit 6 realisiert sein, ohne jedoch zwingend hierauf beschränkt zu sein. Im Hinblick auf eine einfache und kostengünstige Ausgestaltung des Lenkrads 20 ist es von Vorteil, wenn die Steuerung der Heizbetriebsart und der Detektionsbetriebsart durch eine einzige Steuereinrichtung bzw. Recheneinheit 6 realisiert ist, da diese in einfacher Weise die periodisch abwechselnde Aktivierung der jeweiligen Betriebsart vornehmen kann.

Bei dem in Fig. 11 dargestellten Lenkrad 20 bildet der Heizleiter 22 der Widerstandsheizung gleichzeitig auch die Berührelektrode 22 mit Kapazität C der Vorrichtung 1, wie in Fig. 11 zu erkennen ist. Mit anderen Worten bildet der wenigstens eine Heizleiter 22 den RC-Filter der Vorrichtung 1.

Die Heizbetriebsart der Widerstandsheizung und die Detektionsbetriebsart der Vorrichtung 1 werden bei dem vorliegenden Ausführungsbeispiel periodisch alternierend geschaltet, so dass die Beheizung des Lenkrads (sofern sie von einem Benutzer überhaupt angefordert ist) und die Berührungsdetektion (z. B. Hand-On-Erkennung) in zeitlich abwechselnder Folge am Lenkrad 20 stattfinden kann.

Gemäß einer vorteilhaften Weiterbildung des Erfindungsgegenstands weist das Lenkrad einen metallischen Lenkradkern auf, der mit einem vorherbestimmten elektrischen Potential beaufschlagt ist oder potentialfrei gehalten ist. Das vorherbestimmte elektrische Potential ist bevorzugt ein gemeinsames Bezugspotenzial der Vorrichtung zur Berührungsdetektion sowie der Widerstandsheizung und kann einem in Fahrzeugen üblicherweise bereitgestellten Massepotential (GND) entsprechen.

In Fig. 11 ist ferner ein Lenkradkern 21 des Lenkrads 20 zu erkennen. Der Lenkradkern 21 ist aus einem metallischen Werkstoff gebildet. Der metallische Lenkradkern 21 kann mit einem vorherbestimmten elektrischen Potential beaufschlagt sein (nicht dargestellt) oder potentialfrei gehalten sein, wie beispielhaft in Fig. 11 dargestellt ist.

Das vorherbestimmte elektrische Potential kann ein gemeinsames Bezugspotenzial der Vorrichtung 1 sowie der Widerstandsheizung sein, z. B. Fahrzeugmasse bzw. GND. Eine Kopplung des Lenkradkerns mit dem vorbestimmten Bezugspotential kann unmittelbar, das heißt ohne Zwischenschaltung zusätzlicher elektronischer Komponenten, erfolgen oder unter Zwischenschaltung wenigstens einer zusätzlichen elektronischen Komponente, beispielsweise eines Kondensators mit einer Kapazität im Bereich von etwa 10 nF bis 1 µF, ohne jedoch zwingend hierauf beschränkt zu sein.

In Fig. 11 ist lediglich ein einziger Heizleiter 22 dargestellt. Es ist jedoch zu verstehen, dass auch mehrere Heizleiter 22 am Lenkrad 20 angeordnet sein können, z. B. etwa 3 bis 20 Heizleiter oder 5 bis 10, die dann gemeinsam die Berührelektrode der Vorrichtung 1 bilden. Die Heizleiter 22 können auf einer Vorderseite und/oder Rückseite des Lenkrads 20 angeordnet sein oder umfänglich um das Lenkrad 20 bzw. den Lenkradkern 21 angeordnet sein, z. B. spiralförmig. Es ist zu verstehen, dass der/die Heizleiter 22 elektrisch isoliert zum metallischen Lenkradkern 21 am bzw. im Lenkrad 20 angeordnet sind.

Die hierin offenbarte erfindungsgemäße Vorrichtung sowie das erfindungsgemäße Verfahren zur kapazitiven Berührungsdetektion und das Lenkrad sind nicht auf die hierin jeweils offenbarten Ausführungsformen beschränkt, sondern umfassen jeweils auch gleich wirkende weitere Ausführungsformen, die sich aus technisch sinnvollen weiteren Kombinationen der hierin beschriebenen Merkmale sowohl der Vorrichtung als auch des Verfahrens ergeben. Insbesondere sind die hierin vorstehend in der allgemeinen Beschreibung und der Figurenbeschreibung genannten und/oder in den Figuren alleine gezeigten Merkmale und Merkmalskombinationen nicht nur in den jeweils hierin explizit angegebenen Kombinationen, sondern auch in anderen Kombinationen oder in Alleinstellung verwendbar, ohne den Rahmen der vorliegenden Erfindung zu verlassen.

In besonders bevorzugter Ausführung wird die erfindungsgemäße Vorrichtung zur kapazitiven Berührungsdetektion mit wenigstens einer Berührelektrode in einem Fahrzeug, zum Beispiel Kraftfahrzeug, als Teil eines Bedienelements des Fahrzeugs verwendet oder als Hands-On-Erkennung an einem Lenkrad des Fahrzeugs, wobei in diesem Fall wenigstens ein eine Widerstandsheizung bildender Heizleiter die Berührelektrode bildet.

**Bezugszeichenliste**

| 1 | Vorrichtung zur Berührungsdetektion |
|---|---|
| 2 | Berührelektrode |
| 3 | Objekt / Finger |
| 4 | Signalgenerator |
| 5 | Erzeugtes Signal |
| 6 | Recheneinheit |
| 7 | Gefiltertes Signal |
| 8 | Schirmelektrode |
| 9 | Sensorfolie |
| 10 | Erdungselektrode |
| 11 | Bandbreite |
| 12 | Durchlassband |
| 13 | Sperrband |
| 14 | Sensorsubstrat / Leiterplatte |
| 15 | Schutzbeschichtung |
| 16 | Wassertropfen |
| 20 | Lenkrad |
| 21 | Lenkradkern |
| 22 | Kombinierte Heiz-/Berührelektrode |
| 23 | High-Side-Schalter |
| 24 | Low-Side-Schalter |

| C | Kapazität |
|---|---|
| DEC | Dekade |
| f | Frequenz |
| G | Verstärkung |
| GND | Gemeinsames Bezugspotenzial / Erdpotenzial |
| H0..5 | Berührelektrodenspalten |
| φ | Phasenwinkel |
| R | Ohmscher Widerstand |
| V0..4 | Berührelektrodenzeilen |

**Patentansprüche**

**1.** Vorrichtung zur kapazitiven Berührungsdetektion, aufweisend wenigstens eine kapazitive Berührelektrode (2, 2', 2", 2''', 2.1, 2.2, 22) zur Erfassung einer Kapazitätsänderung bei Annäherung eines Objekts (3) an die Berührelektrode (2, 2', 2", 2''', 2.1, 2.2, 22), einen Signalgenerator (4) zur Erzeugung wenigstens eines vorbestimmten periodischen Signals (5) mit vorbestimmter Frequenz und Phase, das der Berührelektrode (2, 2', 2", 2''', 2.1, 2.2, 22) elektrisch zugeführt ist, und eine elektronische Recheneinheit (6), wobei der Signalgenerator (4) vermittels eines ohmschen Widerstands (R) derart mit der Berührelektrode (2, 2', 2", 2''', 2.1, 2.2, 22) elektrisch gekoppelt ist, dass der Widerstand (R) und die Berührelektrode (2, 2', 2", 2''', 2.1, 2.2, 22) bezüglich des der Berührelektrode (2, 2', 2", 2''', 2.1, 2.2, 22) zugeführten Signals (5) ein RC-Filter bilden, wobei die Recheneinheit (6) eingerichtet ist, das von dem RC-Filter gefilterte Signal (7) zu empfangen und eine Abweichung des gefilterten Signals (7) gegenüber dem erzeugten Signal (5) auszuwerten, wobei die Abweichung des gefilterten Signals (7) gegenüber dem erzeugten Signal (5) eine Phasenverschiebung und Amplitudenänderung ist,
**dadurch gekennzeichnet, dass**
das vom Signalgenerator (4) erzeugte Signal (5) eine Überlagerung wenigstens zweier Einzelsignale mit unterschiedlicher Frequenz ist, wobei die unterschiedlichen Frequenzen derart gewählt sind, dass bezüglich der Annäherung des Objekts (3) eine der Frequenzen hauptsächlich eine Phasenverschiebung des gefilterten Signals (7) bewirkt und die wenigstens eine andere der Frequenzen in erster Linie eine Amplitudenänderung des gefilterten Signals (7) bewirkt.

**2.** Vorrichtung nach Anspruch 1,
**dadurch gekennzeichnet, dass**

ein das erzeugte Signal (5) bereitstellender Ausgang des Signalgenerators (4), der Widerstand (R) und die Berührelektrode (2, 2', 2", 2''', 2.1, 2.2, 22) in Reihe geschaltet sind.

3. Vorrichtung nach einem der vorhergehenden Ansprüche,
**dadurch gekennzeichnet, dass**
die Recheneinheit (6) eingerichtet ist, eine elektrische Spannung des gefilterten Signals (7) auszuwerten.

4. Vorrichtung nach einem der vorhergehenden Ansprüche,
**dadurch gekennzeichnet, dass**
die Recheneinheit (6) eingerichtet ist, das gefilterte Signal (7) mittels einer Fourier-Transformation lediglich für die vorbestimmte Frequenz des erzeugten Signals (5) auszuwerten.

5. Vorrichtung nach einem der vorhergehenden Ansprüche,
**dadurch gekennzeichnet, dass**
das erzeugte Signal (5) ein Sinussignal ist.

6. Vorrichtung nach einem der vorhergehenden Ansprüche,
**dadurch gekennzeichnet, dass**
das erzeugte Signal (5) eine Frequenz kleiner oder gleich 100 kHz aufweist, vorzugsweise kleiner oder gleich 50 kHz, noch bevorzugter kleiner oder gleich 10 kHz.

7. Vorrichtung nach einem der vorhergehenden Ansprüche,
**dadurch gekennzeichnet, dass**
die Recheneinheit (6) ferner eingerichtet ist, den Signalgenerator (4) zur Erzeugung des Signals (5) zu steuern.

8. Vorrichtung nach einem der vorhergehenden Ansprüche,
**dadurch gekennzeichnet, dass**
ein Widerstandswert des ohmschen Widerstands (R) größer oder gleich 100 kΩ beträgt.

9. Vorrichtung nach einem der vorhergehenden Ansprüche,
**dadurch gekennzeichnet, dass**
die Berührelektrode (2, 2', 2", 2''', 2.1, 2.2, 22) wenigstens teilweise von einer aktiven Schirmelektrode (8) umgeben ist, der dasselbe vom Signalgenerator (4) erzeugte Signal (5) wie für die Berührelektrode (2, 2', 2", 2''', 2.1, 2.2, 22) zugeführt ist.

10. Vorrichtung nach einem der vorhergehenden Ansprüche,
**dadurch gekennzeichnet, dass**
mehrere Berührelektroden (2, 2', 2", 2''', 22) in einer gitterartigen Anordnung mit mehreren Spalten (H0..H5) und mit mehreren Zeilen (V0..V4) vorgesehen ist, wobei der Signalgenerator (4) vermittels des ohmschen Widerstands (R) wahlweise mit den Berührelektroden (2, 2', 2", 2''', 22) einer der Spalten (H0..H5) oder einer der Zeilen (V0..V4) elektrisch gekoppelt ist und die Recheneinheit (6) eingerichtet ist, wahlweise das gefilterte Signal (7) einer der Zeilen (V0..V4) bzw. einer der Spalten (H0..H5) zu empfangen und auszuwerten.

11. Vorrichtung nach einem der vorhergehenden Ansprüche,
**dadurch gekennzeichnet, dass**
die Berührelektrode (2.1, 2.2, 22) spiralförmig oder vollflächig ausgebildet ist.

12. Verfahren zur kapazitiven Berührungsdetektion, bei dem eine Kapazitätsänderung bei Annäherung eines Objekts (3) an wenigstens eine kapazitive Berührelektrode (2, 2', 2", 2''', 2.1, 2.2, 22) erfasst wird, wobei ein vorbestimmtes periodisches Signal (5) mit vorbestimmter Frequenz und Phase erzeugt wird und der Berührelektrode (2, 2', 2", 2''', 2.1, 2.2, 22) elektrisch zugeführt wird, wobei das erzeugte Signal (5) der Berührelektrode (2, 2', 2", 2''', 2.1, 2.2, 22) vermittels eines ohmschen Widerstands (R) derart zugeführt wird, dass der Widerstand (R) und die Berührelektrode (2, 2', 2", 2''', 2.1, 2.2, 22) bezüglich des der Berührelektrode (2, 2', 2", 2''', 2.1, 2.2, 22) zugeführten Signals (5) ein RC-Filter bilden, durch welches das der Berührelektrode (2, 2', 2", 2''', 2.1, 2.2, 22) zugeführte erzeugte Signal (5) gefiltert wird und eine Abweichung des gefilterten Signals (7) gegenüber dem erzeugten Signal (5) ausgewertet wird, wobei eine Phasenverschiebung und eine Amplitudenänderung des gefilterten Signals (7) gegenüber dem erzeugten Signal (5) als die Abweichung ausgewertet wird,
**dadurch gekennzeichnet, dass**

das erzeugte Signal (5) als eine Überlagerung wenigstens zweier Einzelsignale mit unterschiedlicher Frequenz gebildet wird, wobei die unterschiedlichen Frequenzen derart gewählt werden, dass bezüglich der Annäherung des Objekts (3) eine der Frequenzen hauptsächlich eine Phasenverschiebung des gefilterten Signals (7) bewirkt und die wenigstens eine andere der Frequenzen in erster Linie eine Amplitudenänderung des gefilterten Signals (7) bewirkt.

13. Verfahren nach Anspruch 12,
**dadurch gekennzeichnet, dass**
das erzeugte Signal (5) zuerst durch den Widerstand (R) geleitet wird, bevor es der Berührelektrode (2, 2', 2", 2''', 2.1, 2.2, 22) zugeführt wird.

14. Verfahren nach Anspruch 12 oder 13,
**dadurch gekennzeichnet, dass**
eine elektrische Spannung des gefilterten Signals (7) ausgewertet wird.

15. Verfahren nach einem der Ansprüche 12 bis 14,
**dadurch gekennzeichnet, dass**
der Berührelektrode (2, 2', 2", 2''', 2.1, 2.2, 22) das erzeugte Signal (5) kontinuierlich zugeführt wird, während das gefilterte Signal (7) ausgewertet wird.

16. Verfahren nach einem der Ansprüche 12 bis 15,
**dadurch gekennzeichnet, dass**
das gefilterte Signal (7) mittels einer Fourier-Transformation lediglich für die vorbestimmte Frequenz des erzeugten Signals (5) ausgewertet wird.

17. Verfahren nach einem der Ansprüche 12 bis 16,
**dadurch gekennzeichnet, dass**
einer die Berührelektrode (2, 2', 2", 2''', 2.1, 2.2, 22) wenigstens teilweise umgebenden, aktiven Schirmelektrode (8) dasselbe erzeugte Signal (5) wie für die Berührelektrode (2, 2', 2", 2''', 2.1, 2.2, 22) zugeführt wird.

18. Verfahren nach einem der Ansprüche 12 bis 17,
**dadurch gekennzeichnet, dass**
mehreren Berührelektroden (2, 2', 2", 2''', 2.1, 2.2, 22), die in einer gitterartigen Anordnung mit mehreren Spalten (H0..H5) und mit mehreren Zeilen (V0..V4) bereitgestellt werden, das erzeugte Signal (5) vermittels des ohmschen Widerstands (R) derart zugeführt wird, dass wahlweise den Berührelektroden (2, 2', 2", 2''', 2.1, 2.2, 22) einer der Spalten (H0..H5) oder einer der Zeilen (V0..V4) das erzeugte Signal (5) zugeführt wird und das gefilterte Signal (7) der Zeilen (V0..V4) bzw. Spalten (H0..H5) nacheinander ausgewertet wird.

19. Lenkrad (20) für ein Kraftfahrzeug, aufweisend wenigstens einen eine elektrische Widerstandsheizung bildenden Heizleiter (22) mit einem ohmschen Widerstand (R) und eine Vorrichtung (1) zur kapazitiven Berührungsdetektion in einer Detektionsbetriebsart, insbesondere zur Hands-On-Erkennung, wobei dem Heizleiter (22) in einer Heizbetriebsart mittels wenigstens eines steuerbaren Schaltelements (23, 24) wahlweise elektrische Energie aus einer Energiequelle zuführbar ist, wobei die Vorrichtung nach einem der Ansprüche 1, 3 bis 9 oder 11 ausgebildet ist und der Heizleiter (22) der Widerstandsheizung gleichzeitig die kapazitive Berührelektrode (22) der Vorrichtung (1) und das RC-Filter der Vorrichtung (1) bildet, wobei die Heizbetriebsart der Widerstandsheizung und die Detektionsbetriebsart der Vorrichtung (1) periodisch alternierend geschaltet sind.

20. Lenkrad nach dem vorhergehenden Anspruch,
**gekennzeichnet durch**
einen metallischen Lenkradkern (21), der mit einem vorherbestimmten elektrischen Potential beaufschlagt ist oder potentialfrei gehalten ist.

21. Lenkrad nach einem der beiden vorhergehenden Ansprüche,
**dadurch gekennzeichnet, dass**
die Widerstandsheizung wenigstens fünf, bevorzugt wenigstens zehn, Heizleiter (22) aufweist.

**Claims**

1. Apparatus for capacitive contact detection, having at least one capacitive contact electrode (2, 2', 2", 2‴, 2.1, 2.2, 22) for sensing a change in capacitance when an object (3) approaches the contact electrode (2, 2', 2", 2‴, 2.1, 2.2, 22), a signal generator (4) for generating at least one predetermined periodic signal (5) with a predetermined frequency and phase, which signal is electrically supplied to the contact electrode (2, 2', 2", 2‴, 2.1, 2.2, 22), and an electronic computing unit (6), wherein the signal generator (4) is electrically coupled to the contact electrode (2, 2', 2", 2‴, 2.1, 2.2, 22) by means of an ohmic resistor (R) in such a manner that the resistor (R) and the contact electrode (2, 2', 2", 2‴, 2.1, 2.2, 22) form an RC filter for the signal (5) supplied to the contact electrode (2, 2', 2", 2‴, 2.1, 2.2, 22), wherein the computing unit (6) is configured to receive the signal (7) filtered by the RC filter and to evaluate a deviation of the filtered signal (7) from the generated signal (5), wherein the deviation of the filtered signal (7) from the generated signal (5) is a phase shift and a change in amplitude,
**characterized in that**
the signal (5) generated by the signal generator (4) is a superposition of at least two individual signals with different frequencies, wherein the different frequencies are selected in such a way that, with respect to the approach of the object (3), one of the frequencies mainly causes a phase shift of the filtered signal (7) and the at least one other of the frequencies primarily causes a change in amplitude of the filtered signal (7).

2. Apparatus according to Claim 1,
**characterized in that**
an output of the signal generator (4) that provides the generated signal (5), the resistor (R) and the contact electrode (2, 2', 2", 2‴, 2.1, 2.2, 22) are connected in series.

3. Apparatus according to any one of the preceding claims, **characterized in that**
the computing unit (6) is configured to evaluate an electrical voltage of the filtered signal (7).

4. Apparatus according to any one of the preceding claims, **characterized in that**
the computing unit (6) is configured to evaluate the filtered signal (7) by means of a Fourier transformation only for the predetermined frequency of the generated signal (5).

5. Apparatus according to any one of the preceding claims, **characterized in that**
the generated signal (5) is a sinusoidal signal.

6. Apparatus according to any one of the preceding claims, **characterized in that**
the generated signal (5) has a frequency of less than or equal to 100 kHz, preferably less than or equal to 50 kHz, more preferably less than or equal to 10 kHz.

7. Apparatus according to any one of the preceding claims, **characterized in that**
the computing unit (6) is furthermore configured to control the signal generator (4) for generating the signal (5).

8. Apparatus according to any one of the preceding claims, **characterized in that**
a resistance value of the ohmic resistor (R) is greater than or equal to 100 kΩ.

9. Apparatus according to any one of the preceding claims, **characterized in that**
the contact electrode (2, 2', 2", 2‴, 2.1, 2.2, 22) is at least partially surrounded by an active shield electrode (8), to which the same signal (5) generated by the signal generator (4) as for the contact electrode (2, 2', 2", 2‴, 2.1, 2.2, 22) is supplied.

10. Apparatus according to any one of the preceding claims, **characterized in that**
a plurality of contact electrodes (2, 2', 2", 2‴, 22) are provided in a grid-like arrangement with a plurality of columns (H0..H5) and with a plurality of rows (V0..V4), wherein the signal generator (4) is electrically coupled to the contact electrodes (2, 2', 2", 2‴, 22) of either one of the columns (H0..H5) or one of the rows (V0..V4) by means of the ohmic resistor (R) and the computing unit (6) is configured to receive and evaluate the filtered signal (7) of either one of the rows (V0..V4) or one of the columns (H0..H5).

11. Apparatus according to any one of the preceding claims, **characterized in that**
the contact electrode (2.1, 2.2, 22) is formed in a spiral shape or over the entire surface area.

12. Method for capacitive contact detection, in which a change in capacitance when an object (3) approaches at least one capacitive contact electrode (2, 2', 2", 2''', 2.1, 2.2, 22) is sensed, wherein a predetermined periodic signal (5) with a predetermined frequency and phase is generated and is supplied electrically to the contact electrode (2, 2', 2", 2''', 2.1, 2.2, 22), wherein the generated signal (5) is supplied to the contact electrode (2, 2', 2", 2''', 2.1, 2.2, 22) by means of an ohmic resistor (R) in such a manner that the resistor (R) and the contact electrode (2, 2', 2", 2''', 2.1, 2.2, 22) form an RC filter for the signal (5) supplied to the contact electrode (2, 2', 2", 2''', 2.1, 2.2, 22), by way of which RC filter the generated signal (5) supplied to the contact electrode (2, 2', 2", 2''', 2.1, 2.2, 22) is filtered and a deviation of the filtered signal (7) from the generated signal (5) is evaluated, wherein a phase shift and a change in amplitude of the filtered signal (7) compared to the generated signal (5) is evaluated as the deviation,
   **characterized in that**
   the generated signal (5) is formed as a superposition of at least two individual signals with different frequencies, wherein the different frequencies are selected in such a way that, with respect to the approach of the object (3), one of the frequencies mainly causes a phase shift of the filtered signal (7) and the at least one other of the frequencies primarily causes an change in amplitude of the filtered signal (7).

13. Method according to Claim 12,
   **characterized in that**
   the generated signal (5) is first conducted through the resistor (R) before it is supplied to the contact electrode (2, 2', 2", 2''', 2.1, 2.2, 22).

14. Method according to Claim 12 or 13,
   **characterized in that**
   an electrical voltage of the filtered signal (7) is evaluated.

15. Method according to any one of Claims 12 to 14,
   **characterized in that**
   the generated signal (5) is supplied to the contact electrode (2, 2', 2", 2''', 2.1, 2.2, 22) continuously while the filtered signal (7) is evaluated.

16. Method according to any one of Claims 12 to 15,
   **characterized in that**
   the filtered signal (7) is evaluated by means of a Fourier transformation only for the predetermined frequency of the generated signal (5).

17. Method according to any one of Claims 12 to 16,
   **characterized in that**
   the same generated signal (5) as for the contact electrode (2, 2', 2", 2''', 2.1, 2.2, 22) is supplied to an active shield electrode (8) at least partially surrounding the contact electrode (2, 2', 2", 2''', 2.1, 2.2, 22).

18. Method according to any one of Claims 12 to 17,
   **characterized in that**
   the generated signal (5) is supplied by means of the ohmic resistor (R) to a plurality of contact electrodes (2, 2', 2", 2''', 2.1, 2.2, 22), which are provided in a grid-like arrangement with a plurality of columns (H0..H5) and with a plurality of rows (V0..V4), in such a manner that the generated signal (5) is supplied to the contact electrodes (2, 2', 2", 2''', 2.1, 2.2, 22) of either one of the columns (H0..H5) or one of the rows (V0..V4) and the filtered signal (7) of the rows (V0..V4) or columns (H0..H5) is evaluated one after the other.

19. Steering wheel (20) for a motor vehicle, having at least one heating conductor (22), which forms an electrical resistance heating system and has an ohmic resistor (R), and an apparatus (1) for capacitive contact detection in a detection mode, in particular for hands-on detection, wherein, in a heating mode, the heating conductor (22) can optionally be supplied with electrical energy from an energy source by means of at least one controllable switching element (23, 24), wherein the apparatus is designed according to any one of Claims 1, 3 to 9 or 11 and the heating conductor (22) of the resistance heating system simultaneously forms the capacitive contact electrode (22) of the apparatus (1) and the RC filter of the apparatus (1), wherein the heating mode of the resistance heating system and the detection mode of the apparatus (1) are periodically switched in alternation.

20. Steering wheel according to the preceding claim,
   **characterized by**

a metallic steering wheel core (21), which has a predetermined electrical potential applied to it or is kept at zero potential.

21. Steering wheel according to either one of the two preceding claims,
**characterized in that**
the resistance heating system has at least five, preferably at least ten, heating conductors (22).


## Revendications

1. Dispositif de détection de contact capacitif, qui comprend au moins une électrode tactile capacitive (2, 2', 2", 2‴, 2.1, 2.2, 22) pour détecter un changement de capacité lorsqu'un objet (3) se rapproche de l'électrode tactile (2, 2', 2", 2‴, 2.1, 2.2, 22), un générateur de signaux (4) pour générer au moins un signal périodique prédéfini (5) ayant une fréquence et une phase prédéfinies, ledit signal étant envoyé par voie électrique à l'électrode tactile (2, 2', 2", 2‴, 2.1, 2.2, 22), et une unité de calcul électronique (6), le générateur de signaux (4) étant couplé électriquement à l'électrode tactile (2, 2', 2", 2‴, 2.1, 2.2, 22) par le biais d'une résistance ohmique (R) de façon que la résistance (R) et le condensateur (C) de l'électrode tactile (2, 2', 2", 2‴, 2.1, 2.2, 22) forment un filtre RC pour le signal (5) envoyé à l'électrode tactile (2, 2', 2", 2‴, 2.1, 2.2, 22), l'unité de calcul (6) étant conçue pour recevoir le signal (7) filtré par le filtre RC et pour évaluer un écart du signal filtré (7) par rapport au signal (5) généré, l'écart du signal filtré (7) par rapport au signal (5) généré étant un déphasage et un changement d'amplitude, **caractérisé en ce que**
le signal (5) généré par le générateur de signaux (4) est une superposition d'au moins deux signaux individuels de fréquences différentes, les différentes fréquences étant choisies de telle sorte que, lorsque l'objet (3) se rapproche, l'une des fréquences provoque principalement un déphasage du signal filtré (7) et l'au moins une autre des fréquences provoque en premier lieu un changement d'amplitude du signal filtré (7).

2. Dispositif selon la revendication 1,
**caractérisé en ce que**
une sortie du générateur de signaux (4) fournissant le signal (5) généré, la résistance (R) et l'électrode tactile (2, 2', 2", 2‴, 2.1, 2.2, 22) sont montées en série.

3. Dispositif selon l'une quelconque des revendications précédentes, **caractérisé en ce que**
l'unité de calcul (6) est conçue pour évaluer une tension électrique du signal filtré (7).

4. Dispositif selon l'une quelconque des revendications précédentes, **caractérisé en ce que**
l'unité de calcul (6) est conçue pour évaluer le signal filtré (7) au moyen d'une transformée de Fourier uniquement pour la fréquence prédéfinie du signal (5) généré.

5. Dispositif selon l'une quelconque des revendications précédentes, **caractérisé en ce que**
le signal (5) généré est un signal sinusoïdal.

6. Dispositif selon l'une quelconque des revendications précédentes, **caractérisé en ce que**
le signal (5) généré a une fréquence inférieure ou égale à 100 kHz, de préférence inférieure ou égale à 50 kHz, encore plus préférablement inférieure ou égale à 10 kHz.

7. Dispositif selon l'une quelconque des revendications précédentes, **caractérisé en ce que**
l'unité de calcul (6) est en outre conçue pour commander le générateur de signaux (4) pour générer le signal (5).

8. Dispositif selon l'une quelconque des revendications précédentes, **caractérisé en ce que**
une valeur de résistance de la résistance ohmique (R) est supérieure ou égale à 100 kΩ.

9. Dispositif selon l'une quelconque des revendications précédentes, **caractérisé en ce que**
l'électrode tactile (2, 2', 2", 2‴, 2.1, 2.2, 22) est au moins partiellement entourée d'une électrode de blindage active (8) à laquelle est envoyé le même signal (5) que celui généré par le générateur de signaux (4) pour l'électrode tactile (2, 2', 2", 2‴, 2.1, 2.2, 22).

10. Dispositif selon l'une quelconque des revendications précédentes, **caractérisé en ce que**
plusieurs électrodes tactiles (2, 2', 2", 2‴, 22) sont prévues dans un agencement en grille comportant plusieurs colonnes (H0..H5) et plusieurs rangées (V0..V4), le générateur de signaux (4) étant électriquement couplé sélectivement par le biais de la résistance ohmique (R) aux électrodes tactiles (2, 2', 2", 2''', 22) de l'une des colonnes (H0..H5) ou de l'une des rangées (V0..V4) et l'unité de calcul (6) étant conçue pour recevoir et évaluer sélectivement le signal filtré (7) de l'une des rangées (V0..V4) ou de l'une des colonnes (H0..H5).

11. Dispositif selon l'une quelconque des revendications précédentes, **caractérisé en ce que** l'électrode tactile (2.1, 2.2, 22) est réalisée en forme de spirale ou sur toute la surface.

12. Procédé de détection de contact capacitif, dans lequel un changement de capacité est détecté lorsqu'un objet (3) se rapproche d'au moins une électrode tactile capacitive (2, 2', 2", 2''' 2.1, 2.2, 22), un signal périodique prédéfini (5) ayant une fréquence et une phase prédéfinies est généré et envoyé par voie électrique à l'électrode tactile (2, 2', 2", 2''' 2.1, 2.2, 22), le signal (5) généré étant envoyé à l'électrode tactile (2, 2', 2", 2''' 2.1, 2.2, 22) par le biais d'une résistance ohmique (R) de façon que la résistance (R) et le condensateur (C) de l'électrode tactile (2, 2', 2", 2''' 2.1, 2.2, 22) forment un filtre RC pour le signal (5) envoyé à l'électrode tactile (2, 2', 2", 2''' 2.1, 2.2, 22), par lequel le signal (5) généré envoyé à l'électrode tactile (2, 2', 2", 2''' 2.1, 2.2, 22) est filtré et un écart du signal filtré (7) par rapport au signal (5) généré est évalué, un déphasage et un changement d'amplitude du signal filtré (7) par rapport au signal (5) généré étant évalués en tant qu'écart, **caractérisé en ce que** le signal (5) généré est établi sous la forme d'une superposition d'au moins deux signaux individuels de fréquences différentes, les différentes fréquences étant choisies de telle sorte que, lorsque l'objet (3) se rapproche, l'une des fréquences provoque principalement un déphasage du signal filtré (7) et l'au moins une autre des fréquences provoque en premier lieu un changement d'amplitude du signal filtré (7).

13. Procédé selon la revendication 12,
**caractérisé en ce que**
le signal (5) généré est d'abord transmis à travers la résistance (R) avant d'être envoyé à l'électrode tactile (2, 2', 2", 2''', 2.1, 2.2, 22).

14. Procédé selon la revendication 12 ou 13,
**caractérisé en ce que**
une tension électrique du signal filtré (7) est évaluée.

15. Procédé selon l'une des revendications 12 à 14,
**caractérisé en ce que**
le signal (5) généré est envoyé en continu à l'électrode tactile (2, 2', 2", 2''', 2.1, 2.2, 22) pendant que le signal filtré (7) est évalué.

16. Procédé selon l'une quelconque des revendications 12 à 15, **caractérisé en ce que**
le signal filtré (7) est évalué au moyen d'une transformée de Fourier uniquement pour la fréquence prédéfinie du signal (5) généré.

17. Procédé selon l'une quelconque des revendications 12 à 16, **caractérisé en ce que**
le même signal (5) que celui généré pour l'électrode tactile (2, 2', 2", 2''', 2.1, 2.2, 22) est envoyé à une électrode de blindage active (8) entourant au moins partiellement l'électrode tactile (2, 2', 2", 2''', 2.1, 2.2, 22).

18. Procédé selon l'une quelconque des revendications 12 à 17, **caractérisé en ce que**
le signal (5) généré est envoyé par le biais de la résistance ohmique (R) à plusieurs électrodes tactiles (2, 2', 2", 2''', 2.1, 2.2, 22), qui sont prévues dans un agencement en grille comportant plusieurs colonnes (H0..H5) et plusieurs rangées (V0..V4) de telle sorte que le signal (5) généré est envoyé sélectivement aux électrodes tactiles (2, 2', 2", 2''', 2.1, 2.2, 22) de l'une des colonnes (H0..H5) ou de l'une des rangées (V0..V4) et que le signal filtré (7) des rangées (V0..V4) ou des colonnes (H0..H5) est évalué séquentiellement.

19. Volant de direction (20) pour un véhicule automobile, qui comprend au moins un conducteur chauffant (22) formant un système de chauffage à résistance électrique comportant une résistance ohmique (R) et un dispositif (1) de détection de contact capacitif dans un mode de fonctionnement de détection, en particulier pour la détection de la présence des mains, de l'énergie électrique pouvant être envoyée sélectivement au conducteur chauffant (22) depuis une source d'énergie dans un mode de fonctionnement de chauffage au moyen d'au moins un élément de commutation commandable (23, 24), le dispositif étant conçu selon l'une quelconque des revendications 1, 3 à 9 ou 11, et le conducteur chauffant (22) du système de chauffage à résistance électrique formant simultanément l'électrode tactile capacitive (22) du dispositif (1) et le filtre RC du dispositif (1), le mode de fonctionnement de chauffage du système de chauffage à résistance électrique et le mode de fonctionnement de détection du dispositif (1) étant commutés périodiquement en alternance.

**20.** Volant de direction selon la revendication précédente, **caractérisé par**
un cœur de volant de direction (21) métallique, qui est soumis à un potentiel électrique prédéterminé ou est maintenu sans potentiel.

**21.** Volant de direction selon l'une des deux revendications précédentes,
**caractérisé en ce que**
le système de chauffage à résistance électrique comprend au moins cinq, de préférence au moins dix, conducteurs chauffants (22).

Fig. 1

EP 4 183 048 B1

Fig. 2

Fig. 3

Fig. 4

Fig. 5

EP 4 183 048 B1

Fig. 6

Fig. 7

Fig. 8

Fig. 9

EP 4 183 048 B1

Fig. 10

Fig. 11

EP 4 183 048 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 10352731 B2
- US 2008122458 A1
- WO 9701835 A1
- US 2013076374 A1